# DEMANDE DE BREVET EUROPEEN

(11) **EP 4 343 838 A1**
(43) Date de publication de la demande: **27.03.2024**
(21) Numéro de dépôt: 23198926.0
(22) Date de dépôt: 21.09.2023
(51) Int. Cl.: H01L 23/66, H01P 1/387, H04B 1/18, H04B 1/525

(54) **MODULE FRONTAL D ÉMISSION ET/OU RÉCEPTION RADIOFRÉQUENCE ET PROCÉDÉ DE FABRICATION ASSOCIÉ**

(30) Priorité: 21.09.2022 FR 2209567
(71) Demandeur: Commissariat à l'énergie atomique et aux énergies alternatives, 75015 Paris (FR)
(72) Inventeur: SERHAN, Ayssar, 38054 Grenoble cedex 09 (FR); GIRY, Alexandre, 38054 Grenoble cedex 09 (FR); COUDRAIN, Perceval, 38054 Grenoble cedex 09 (FR); MICHEL, Jean-Philippe, 38054 Grenoble cedex 09 (FR); REYNIER, Pascal, 38054 Grenoble Cedex 09 (FR)
(74) Mandataire: Hautier IP

(57) **Abrégé**

Une nouvelle solution d'intégration est proposée qui permet la fabrication de modules frontaux 1 d'émission et/ou de réception radiofréquence avec circuit(s) intégré(s) radiofréquence 11 et composant(s) magnétique(s) auto-polarisé(s) 20 intégré(s) sur une technologie du type « Wafer Level Packaging ». Cette solution d'intégration simple et flexible permet de concevoir des modules frontaux performants, compacts et à bas coût.

## Description

### DOMAINE TECHNIQUE

La présente invention concerne le domaine de l'intégration de modules frontaux d'émission et réception radiofréquence. Elle trouve des applications particulièrement avantageuses dans les domaines de la téléphonie mobile, de l'Infrastructure de Télécommunication, de l'automobile, de la défense et du spatial.

### ETAT DE LA TECHNIQUE

Des efforts significatifs sont actuellement fournis par l'industrie et la recherche pour intégrer des fonctions magnétiques, telles que celles des circulateurs, voire des isolateurs et/ou autres gyrateurs, à base de matériau magnétique auto-polarisé/sans aimant dans des modules frontaux d'émission et/ou de réception radiofréquence. La nécessité de réduire la taille des modules frontaux est en effet connue et des solutions d'intégration sont proposées pour y répondre. Trois axes principaux d'innovation peuvent être dégagés qui s'articulent autour de développements relatifs aux technologies de packaging, de développements relatifs aux techniques d'intégration tridimensionnelle et de développements relatifs aux matériaux magnétiques eux-mêmes.

Il existe ainsi plusieurs approches qui peuvent être classées selon la nature semiconductrice ou diélectrique du substrat sur lequel la fonction magnétique considérée doit être intégrée.

Pour l'intégration monolithique d'une fonction magnétique sur un substrat semi-conducteur, se posent principalement deux défis à surmonter :
- La synthèse d'un matériau magnétique auto-polarisé/sans aimant présentant les propriétés ferromagnétiques requises pour permettre un comportement réciproque et de faibles pertes, et
- L'intégration du matériau permettant de réaliser la fonction magnétique dans un substrat semi-conducteur avec peu d'étapes additionnelles de procédé de fabrication et sans dégrader les propriétés ferromagnétiques du matériau magnétique auto-polarisé/sans aimant et/ou les composants semi-conducteurs alentour.

En tant que réponses à ces défis, il est notamment connu :
- une première solution d'intégration consistant à déposer le matériau magnétique, obtenu préalablement par l'enduction sous centrifugation d'un mélange de ferrite et de résine photosensible, dans une cavité formée dans un substrat semi-conducteur, et
- une deuxième solution décrite dans les documents de brevet référencés US 2020/0153071 A1 et US 2019/0131681 A1qui concernent des procédés de fabrication d'un circulateur auto-polarisé dans un circuit intégré.

La première solution présente l'avantage d'être compatible avec les procédés de fabrication CMOS. Cependant, cette solution présente au moins l'une des limitations majeures suivantes :
- Un coût de fabrication élevé,
- Un impact négatif sur le rendement du procédé de fabrication CMOS,
- Un accroissement de la perte d'insertion lorsque le substrat est peu résistif, et
- Une limitation de l'épaisseur du dépôt du matériau magnétique limitant sa tenue en puissance et sa fréquence d'utilisation.

La deuxième solution consiste :
- à fournir un circuit intégré sur un substrat III-V,
- à créer ou graver une cavité en face arrière du substrat III-V et sous le circuit intégré, puis
- à déposer le matériau magnétique nécessaire à la réalisation de la fonction magnétique désirée.

Le matériau magnétique peut être déposé/coulé dans la cavité ou un palet du matériau magnétique peut être reporté dans la cavité. Dans ce dernier cas, une résine époxy non-conductrice peut être utilisée pour combler un espace entre le palet de matériau magnétique et les parois latérales de la cavité, de sorte à stabiliser le palet y compris dans des conditions de fortes vibrations et à s'assurer qu'aucun matériau étranger ne vienne introduire des défauts structuraux, en particulier au cours des étapes subséquentes de l'assemblage.

Cette deuxième solution présente au moins l'un des inconvénients suivants :
- Le gaspillage du substrat semi-conducteur et de l'espace de support qu'il offre, notamment lorsque le substrat est de type III-V, de tels substrats étant limités en taille,
- La limitation de l'épaisseur du matériau magnétique par l'épaisseur du substrat, d'autant plus que les substrats sont souvent amincis, et
- La nécessité de graver une cavité plus large que le matériau magnétique et de remplir l'espace libre restant de sorte à stabiliser mécaniquement le palet magnétique.

Comme susmentionné, il existe également des méthodes d'intégration de fonctions magnétiques dans des substrats diélectriques (substrat céramique, PCB, etc.). Une de ces méthodes est décrite dans le document de brevet référencé US 2018/0166763 A1. La solution proposée dans ce document comprend d'une part la réalisation d'un disque de matériau magnétique auto-polarisé, d'autre part la réalisation d'une cavité dans le substrat diélectrique. La cavité est destinée à loger le disque magnétique. Une fois le disque inséré dans la cavité formée dans le substrat diélectrique, le tout est recuit pour s'assurer que le palet et le substrat diélectrique soient liés mécaniquement entre eux. D'autres solutions d'intégration de fonctions magnétiques dans des substrats diélectriques comprennent une étape de dépôt du matériau destiné à permettre la fonction magnétique à intégrer dans une cavité formée dans le substrat diélectrique.

Ces méthodes d'intégration dans des substrats présentent au moins l'un des inconvénients suivants :
- Le matériau diélectrique constituant le substrat doit pouvoir supporter des températures de recuit d'au moins 650°C ; De tels diélectriques sont souvent chers ; et atteindre des températures de recuit élevées a également un coût significatif,
- Le prétraitement du substrat diélectrique pour former la ou les cavités représente des étapes de fabrication additionnelles qui augmentent le coût et le temps de fabrication ; et il est difficile d'obtenir des cavités ayant des parois latérales suffisamment bien définies pour permettre une insertion aisée du disque magnétique,
- Lorsque plusieurs fonctions magnétiques sont à intégrer, autant de cavités sont à réaliser dans le substrat diélectrique ; or de telles cavités peuvent affecter significativement l'intégrité mécanique du substrat, notamment si elles sont proches les unes des autres. En outre, l'expansion du matériau diélectrique constituant le substrat est d'autant plus difficile à contrôler pendant le recuit, et
- La dissipation thermique dans les assemblages obtenus n'est généralement pas satisfaisante.

L'on comprend ainsi que l'industrialisation de ces méthodes d'intégration de fonctions magnétiques dans des substrats diélectriques est difficilement envisageable/réalisable.

Un objet de la présente invention est donc de proposer un module frontal d'émission et/ou de réception radiofréquence et un procédé de fabrication associé qui permettent de pallier au moins un, de préférence certains, des inconvénients des solutions antérieures.

Un objet de la présente invention est plus particulièrement de proposer un module frontal d'émission et/ou de réception radiofréquence et un procédé de fabrication associé qui se prêtent avantageusement à une industrialisation.

Un autre objet de la présente invention est de proposer un module frontal d'émission et/ou de réception radiofréquence et un procédé de fabrication associé qui permettent de réduire le coût et/ou la taille et/ou le poids des systèmes radiofréquence embarquant des modules frontaux.

Les autres objets, caractéristiques et avantages de la présente invention apparaîtront à l'examen de la description suivante et des dessins d'accompagnement. Il est entendu que d'autres avantages peuvent être ajoutés.

### RESUME

Pour atteindre cet objectif, on prévoit un module frontal d'émission et/ou de réception radiofréquence comprenant :
- un circuit intégré radiofréquence comprenant au moins deux zones de connexion électrique dont une première zone destinée à recevoir ou émettre un signal et une deuxième zone destinée à être reliée à la masse,
- un palet à base d'un matériau magnétique auto-polarisé comprenant une première surface principale et une deuxième surface principale opposée à la première,
le module frontal étant tel qu'il comprend en outre :
- un premier matériau diélectrique et un deuxième matériau diélectrique formant une couche d'enrobage latéral respective du circuit intégré radiofréquence et du palet en les maintenant mécaniquement en position relative l'un par rapport à l'autre, et
- une couche de redistribution RDL de connexions électriques placée au-dessus de la couche d'enrobage comprenant ledit premier matériau diélectrique, la couche de redistribution RDL comprenant une piste métallique de connexion électrique de signal reliant la deuxième surface principale du palet et ladite première zone de connexion électrique du circuit intégré pour permettre la transmission d'un signal électrique entre le palet et le circuit intégré.

On prévoit également un procédé de fabrication d'un module frontal d'émission et/ou de réception radiofréquence comprenant :
- Fournir un circuit intégré radiofréquence, un palet à base d'un matériau magnétique auto-polarisé, un premier substrat porteur et un second substrat porteur, le circuit intégré radiofréquence comprenant plusieurs zones de connexion électrique dont une première zone destinée à recevoir et/ou émettre un signal électrique et une deuxième zone destinée à être reliée à la masse, et le palet comprenant une première surface principale et une deuxième surface principale opposée à la première, puis
- Assembler le circuit intégré radiofréquence et le palet en se servant du premier substrat porteur comme support pour des premières étapes de fabrication du module frontal, puis comme substrat de transfert sur le second substrat support pour des deuxièmes étapes de fabrication du module frontal ; en utilisant au moins l'un parmi un premier matériau diélectrique et un deuxième matériau diélectrique pour former, par un procédé de conditionnement de type FOWLP, une couche d'enrobage latéral respective dudit circuit intégré radiofréquence (11) et du palet et les maintenir mécaniquement en position relative l'un par rapport à l'autre ; en formant une couche de redistribution RDL de connexions électriques placée au-dessus de la couche d'enrobage comprenant ledit premier matériau diélectrique et comprenant une piste métallique de connexion électrique reliant la deuxième surface principale du palet et ladite première zone de connexion électrique du circuit intégré pour permettre la transmission d'un signal électrique entre le palet et le circuit intégré.

Ainsi, une nouvelle solution d'intégration est proposée qui permet la fabrication de modules frontaux d'émission et/ou de réception radiofréquence avec composant(s) magnétique(s) auto-polarisé(s) intégré(s) sur une technologie du type « Wafer Level Packaging ». Cette solution d'intégration est simple et flexible.

La solution d'intégration proposée permet de réduire le coût et/ou la taille et/ou le poids des systèmes radiofréquence embarquant des modules frontaux, cet objectif étant atteint notamment en réduisant les distances entre le ou les circuits intégrés (PA, LNA, etc.), le composant magnétique (circulateur, isolateur, gyrateur, etc.) et l'antenne.

La solution proposée met en oeuvre des techniques d'intégration :
- pour intégrer un matériau magnétique auto-polarisé réalisant la fonction magnétique du module frontal, et
- pour assembler le ou les circuits intégrés radiofréquence du module frontal dans un même package/module.

Plus particulièrement, la solution proposée présente au moins l'un des avantages suivants sur l'état de la technique :
- Pas d'utilisation d'un aimant externe (souvent très encombrant) pour polariser le matériau magnétique,
- Le gaspillage de large surface de substrats semi-conducteurs coûteux est évité, ce qui est particulièrement intéressant dès lors que les substrats sont de type III-V,
- Une flexibilité dans le choix de l'épaisseur, et du facteur de forme, du matériau magnétique est offerte, ce qui permet l'optimisation de la fonction magnétique à intégrer, sans compromettre le niveau de perte d'insertion et en assurant la tenue en puissance,
- Un meilleur contrôle de la position du matériau magnétique, y compris dans des conditions de fortes vibrations en fonctionnement ou d'usage,
- La nécessité d'un adhésif ou d'un mastic de remplissage (à base de résine époxy) est évitée. Les performances sont ainsi plus stables relativement aux fréquences et aux températures de fonctionnement ou d'usage,
- La fabrication des composants du module, notamment les éléments semi-conducteurs des circuits intégrés radiofréquence, peut être réalisée aux moyens de diverses techniques connues de la microélectronique, sans limitation significative de ces moyens et techniques,
- Une compatibilité avec des substrats de 300 mm de diamètre est possible pour une réduction correspondante du coût de fabrication et un potentiel encore accru en termes de capacité d'industrialisation,
- Une réduction de la consommation en énergie des modules frontaux est atteinte par réduction des pertes d'interconnexion entre les éléments réalisant la fonction magnétique intégrée et les voies de réception et/ou d'émission, augmentant par-là l'efficacité en émission et la sensibilité en réception,
- Une compatibilité est atteinte avec l'intégration d'amplificateurs de puissance présentant des architectures avancées, telles que des amplificateurs de puissance à modulation de charge à base de circulateur(s), et ce avec un facteur de forme justifiant leur compacité,
- Une amélioration de l'efficacité spectrale est atteinte en permettant l'émission et la réception simultanées dans une même bande de fréquence (Full-duplex),
- Une protection du ou des amplificateurs de puissance à la désadaptation d'impédance est atteinte,
- Une possibilité de blindage du champ électrique est offerte en conservant la possibilité d'utiliser des vias à travers les matériaux diélectriques (notamment selon la technologie connue sous l'acronyme TMV pour « Through Mold Via » selon la terminologie anglo-saxonne) si besoin (et notamment sur des parties spécifiques du circuit),
- Une compatibilité est atteinte avec la fabrication de modules frontaux radiofréquence présentant une topologie de circulateur à guide d'onde intégré dans le substrat (ou SIW pour « Substrate Integrated Waveguide » selon la terminologie anglo-saxonne), et
- La possibilité est offerte d'ajouter, aux modules frontaux radiofréquence, un radiateur dans le but d'améliorer la dissipation thermique des modules.

En outre, la solution proposée permet d'exploiter la technologie dite des « Piliers en cuivre » (ou « Copper Pillars » selon la terminologie anglo-saxonne) développée au CEA-Leti (Laboratoire d'électronique et de technologie de l'information du CEA).

### BREVE DESCRIPTION DES FIGURES

Les buts, objets, ainsi que les caractéristiques et avantages de l'invention ressortiront mieux de la description détaillée de modes de réalisation d'un module frontal et de modes de mis en oeuvre d'un procédé de fabrication associé qui sont illustrés par les dessins d'accompagnement suivants dans lesquels :
Les figures 1 à 9 illustrent différentes étapes d'un premier mode de mise en oeuvre, dit « puce en premier » ou « Die First » selon la terminologie anglo-saxonne, d'un procédé de fabrication d'un module frontal radiofréquence selon un premier mode de réalisation qui est illustré sur la figure 10 ; les figures 3A et 3B illustrent des alternatives de ce procédé.
La figure 10 illustre une vue en coupe d'un premier mode de réalisation d'un module frontal radiofréquence selon l'invention obtenu par mise en oeuvre du procédé de fabrication « Die First ».
La figure 11 illustre une vue en coupe d'un montage, sur une carte d'évaluation, du module frontal radiofréquence illustré sur la figure 10.
Les figures 12 à 21 illustrent différentes étapes d'un deuxième mode de mise en oeuvre, dit « Couche de redistribution en premier » ou « RDL (redistribution layer) First » suivant la terminologie anglo-saxonne, d'un procédé de fabrication d'un module frontal radiofréquence selon un deuxième mode de réalisation qui est illustré sur la figure 22 ; les figures 17A et 17B illustrent des alternatives de ce procédé.
La figure 22 illustre une vue en coupe d'un deuxième mode de réalisation d'un module frontal radiofréquence selon l'invention obtenu par mise en oeuvre du procédé de fabrication « RDL First ».
La figure 23 illustre une vue en coupe d'un montage, sur une carte d'évaluation, du module frontal radiofréquence illustré sur la figure 22.
Les figures 24 à 30 illustrent différentes étapes d'un troisième mode de mise en oeuvre, dit « puce en premier » ou « Die First » selon la terminologie anglo-saxonne, d'un procédé de fabrication d'un module frontal radiofréquence selon un troisième mode de réalisation qui est illustré sur la figure 31.
La figure 31 illustre une vue en coupe d'un troisième mode de réalisation du module frontal radiofréquence selon l'invention obtenu par mise en oeuvre du procédé de fabrication « Die First ».
La figure 32 illustre une vue en coupe d'un montage, sur une carte d'évaluation, du module frontal radiofréquence illustré sur la figure 31.
Les figures 33 à 40A illustrent différentes étapes d'un quatrième mode de mise en oeuvre, dit « Couche de redistribution en premier » ou « RDL (redistribution layer) First » suivant la terminologie anglo-saxonne, d'un procédé de fabrication d'un module frontal radiofréquence selon un quatrième mode de réalisation qui est illustré sur la figure 41 ; les figures 37A, 38A et 40A illustrent une alternative de ce procédé.
La figure 41 illustre une vue en coupe d'un quatrième mode de réalisation du module frontal radiofréquence selon l'invention obtenu par mise en oeuvre du procédé de fabrication « RDL (redistribution layer) First ».
La figure 42 illustre une vue en coupe d'un montage, sur une carte d'évaluation, du module frontal radiofréquence illustré sur la figure 41.
Les figures 43 à 45 illustrent respectivement une vue de dessus, une vue de trois quarts de dessous et une vue de trois quarts de dessus du montage illustré sur la figure 42 et correspondant au schéma électronique de la figure 46.
Les figures 46 et 46A à 46I illustrent chacune un schéma électrique d'un exemple de module frontal radiofréquence fabricable par mise en oeuvre d'un quelconque des modes de mise en oeuvre du procédé de fabrication selon l'invention.
Les figures 47A et 47B illustrent respectivement une vue en perspective et une vue de dessus d'un exemple de composant magnétique, et plus particulièrement d'un exemple de circulateur, potentiellement compris dans l'un quelconque des différents modes de réalisation du module frontal radiofréquence selon l'invention et potentiellement fabriqué selon l'un quelconque des différents modes de mise en oeuvre du procédé de fabrication selon l'invention.
La figure 48A illustre une vue en coupe d'un circuit intégré radiofréquence compris dans les modes de réalisation du module frontal radiofréquence qui sont illustrés sur les figures 10 et 22.
La figure 48B illustre une vue en coupe du circuit intégré radiofréquence compris dans les modes de réalisation du module frontal radiofréquence qui sont illustrés sur les figures 31 et 41.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différents niveaux, étages, couches ou éléments ne sont pas nécessairement représentatives de la réalité.

### DESCRIPTION DÉTAILLÉE

Avant d'entamer une revue détaillée des modes de réalisation de l'invention, sont énoncées ci-après des caractéristiques optionnelles de différents modes de réalisation du module selon l'invention qui peuvent éventuellement être utilisées en association ou alternativement :
Selon un exemple, la première surface principale du palet peut être reliée électriquement à un premier plot de connexion externe du module destiné à être relié à la masse, et la deuxième zone de connexion électrique du circuit intégré radiofréquence peut être reliée électriquement au premier plot ou à un deuxième plot de connexion externe du module et destiné à être relié à la masse également. En complément, la première surface principale du palet et la deuxième zone de connexion électrique du circuit intégré radiofréquence peuvent être reliées par une piste conductrice de masse formée au contact de la couche d'enrobage comprenant le premier matériau diélectrique, du côté opposé à la couche de redistribution RDL.

Selon un exemple, le composant magnétique peut constituer ou comprendre au moins l'un parmi un circulateur, un gyrateur et un isolateur.

Selon un exemple, le premier matériau diélectrique et le deuxième matériau diélectrique peuvent s'étendre sur un même niveau du module frontal en formant une unique couche dans laquelle le circuit intégré radiofréquence et le palet sont placés. Le cas échéant, le premier matériau diélectrique et le deuxième matériau diélectrique sont confondus entre eux. En complément, la première surface principale du palet et la deuxième zone de connexion électrique du circuit intégré radiofréquence peuvent être reliées par une piste conductrice de masse formée au contact de la couche d'enrobage comprenant le premier matériau diélectrique, du côté opposé à la couche de redistribution RDL.

Selon un exemple alternatif au précédent, le premier matériau diélectrique peut former une première couche dans laquelle le circuit intégré radiofréquence est intégré et le deuxième matériau diélectrique peut former une deuxième couche dans laquelle le palet est intégré, la deuxième couche du deuxième matériau diélectrique correspondant en tout ou partie à des couches diélectriques constitutives de la couche de distribution RDL de connexions électriques. Par exemple le premier matériau diélectrique et le deuxième matériau diélectrique sont différents entre eux.

Selon un exemple, le matériau magnétique auto-polarisé constituant le palet peut être à base de l'un au moins parmi : une ferrite et une hexaferrite.

Selon un exemple, une épaisseur du palet entre ses surfaces principales peut être supérieure à une épaisseur du circuit intégré radiofréquence entre sa face avant et sa face arrière.

Selon un exemple, au moins une piste métallique de connexion électrique peut avoir une géométrie tridimensionnelle et/ou peut être formée sur au moins deux niveaux métalliques de connexion électrique interconnectés entre eux par l'intermédiaire de vias métalliques.

Selon un exemple, le circuit intégré radiofréquence peut présenter au moins un via s'étendant depuis la face arrière du circuit intégré radiofréquence à travers un substrat semiconducteur dans lequel sont formés des composants actifs du circuit intégré radiofréquence, de sorte que la face arrière du circuit intégré radiofréquence constitue une zone de connexion à la masse du circuit intégré radiofréquence. Le module frontal selon cet exemple montre que son procédé de fabrication est compatible non seulement avec le report d'un circuit intégré radiofréquence de conception simple, mais également avec le report d'un circuit intégré radiofréquence de conception plus complexe, faisant notamment intervenir des connexions sur sa face avant et sur sa face arrière.

Selon un exemple, le module frontal peut être exempt d'un adhésif ou d'un mastic de remplissage, tel qu'une résine époxy non-conductrice, au moins autour de parois latérales du palet.

Selon un exemple, le module frontal peut être exempt d'aimant permanent.

Toujours avant d'entamer une revue détaillée de modes de réalisation de l'invention, sont énoncées ci-après des caractéristiques optionnelles de différents modes de mise en oeuvre du procédé de fabrication selon l'invention qui peuvent éventuellement être utilisées en association ou alternativement :
Selon un exemple, le procédé peut comprendre en outre la formation d'une liaison électrique entre la première surface principale du palet et un premier plot de connexion externe du module destiné à être relié à la masse, et la formation d'une liaison électrique entre une deuxième zone de connexion électrique du circuit intégré radiofréquence et un premier plot ou un deuxième plot de connexion externe du module et destiné à être relié à la masse également. En complément, le procédé peut comprendre la formation d'une liaison électrique entre la première surface principale du palet et la deuxième zone de connexion électrique du circuit intégré radiofréquence par une piste conductrice de masse formée au contact de la couche d'enrobage comprenant le premier matériau diélectrique, du côté opposé à la couche de redistribution RDL.

Selon un exemple, l'un parmi le circuit intégré radiofréquence et le palet peut d'abord être reporté sur l'un ou l'autre parmi le premier substrat support et le deuxième substrat support avant que l'un ou l'autre parmi le premier matériau diélectrique et le deuxième matériau diélectrique ne soit utilisé pour le maintenir mécaniquement dans la position de son report et l'autre parmi le circuit intégré radiofréquence et le palet peut d'abord être reporté sur l'un ou l'autre parmi le premier substrat support et le deuxième substrat support avant que l'un ou l'autre parmi le premier matériau diélectrique et le deuxième matériau diélectrique ne soit utilisé pour le maintenir mécaniquement dans la position de son report.

Selon une première variante, le procédé peut comprendre en outre :
- un report du circuit intégré radiofréquence et du palet sur le premier substrat porteur, le circuit intégré radiofréquence étant reporté sur le premier substrat porteur par sa face avant et le palet étant reporté sur le premier substrat porteur par une de ses première et deuxième surfaces principales,
- un dépôt du premier matériau diélectrique sur le premier substrat porteur au moins autour du circuit intégré radiofréquence et du palet,
- un dépôt d'une piste métallique de masse,
   pour obtenir sur le premier substrat porteur une première partie du module frontal, puis
- un transfert de la première partie du module frontal depuis le premier substrat porteur sur le second substrat porteur par la face de la première partie du module frontal sur laquelle est exposée la première piste métallique de masse,
   de sorte que la première partie du module frontal puisse être traitée depuis sa surface exposée après son transfert, pour finir de former le module frontal.

Selon un exemple de la première variante, le procédé peut comprendre en outre :
- Une formation de la piste métallique de connexion électrique, soit sur la surface exposée de la première partie du module frontal après son transfert, soit sur le premier substrat porteur avant report du circuit intégré radiofréquence et du palet.

Selon un autre exemple de la première variante, la formation de la piste métallique de connexion électrique peut comprendre la création d'au moins deux niveaux métalliques de connexion électrique interconnectés entre eux par l'intermédiaire de vias métalliques à travers un troisième matériau diélectrique.

Selon un autre exemple de la première variante, le procédé peut comprendre en outre, avant le dépôt de la piste métallique masse :
- Un meulage du premier matériau diélectrique pour exposer la face arrière du circuit intégré radiofréquence et la surface principale du palet opposée à celle par laquelle le palet a été reporté sur le premier substrat porteur.

Selon un autre exemple de sa première variante, le procédé peut comprendre en outre, lorsque le dépôt de la piste métallique de connexion électrique est réalisé sur le premier substrat porteur avant report du circuit intégré radiofréquence et du palet :
- Une formation sur la piste métallique de connexion électrique d'un pilier métallique de connexion électrique. Le pilier métallique peut par exemple présenter une hauteur supérieure à la plus grande parmi une épaisseur du circuit intégré radiofréquence entre sa face avant et sa face arrière et une épaisseur du palet entre ses surfaces principales. Par exemple, la formation de la piste métallique de connexion électrique peut comprendre la création d'au moins deux niveaux métalliques de connexion électrique interconnectés entre eux par l'intermédiaire de vias métalliques à travers un troisième matériau diélectrique. Par exemple, le procédé peut comprendre en outre, lorsque le dépôt du premier matériau diélectrique est tel qu'il recouvre le circuit intégré radiofréquence et/ou le palet, et le cas échéant le sommet du pilier métallique :
- une étape de meulage du premier matériau diélectrique, potentiellement jusqu'à exposer celle qui parmi la face arrière du circuit intégré radiofréquence et la surface principale du palet opposée à celle par laquelle le palet a été reporté sur le premier substrat porteur est la moins recouverte par le premier matériau diélectrique, et le cas échéant jusqu'à exposer le sommet du pilier métallique.

Selon une deuxième variante, le procédé peut comprendre en outre :
- un report du circuit intégré radiofréquence sur le premier substrat porteur par sa face avant,
- un dépôt du premier matériau diélectrique sur le premier substrat porteur au moins autour du circuit intégré radiofréquence,
pour obtenir, sur le premier substrat porteur, une première partie du module frontal, puis
- un transfert de la première partie du module frontal depuis le premier substrat porteur sur le second substrat porteur par la face de la première partie du module frontal opposée à celle par laquelle la première partie du module frontal repose sur le premier substrat support,
de sorte que la première partie du module frontal puisse être traitée depuis sa surface exposée après son transfert, pour finir de former le module frontal, puis
- un dépôt d'un premier niveau métallique de connexion électrique sur la surface exposée de la première partie du module frontal, de sorte à présenter deux parties électriquement disjointes entre elles, chacune constituant une partie de l'une parmi la piste métallique de connexion électrique et la piste métallique de masse,
- un dépôt du deuxième matériau diélectrique sur le premier niveau métallique de connexion électrique, puis une gravure du deuxième matériau diélectrique, de sorte à former une cavité située en regard de la partie du premier niveau métallique constituant une partie de la piste métallique de connexion électrique et destinée à loger le palet et de sorte à former des vias vers un deuxième niveau métallique de connexion électrique pour chacune parmi la piste métallique de connexion électrique et la piste métallique de masse,
- un report du palet dans la cavité formée,
- un dépôt du deuxième niveau métallique de connexion électrique sur la surface du deuxième matériau diélectrique et la surface principale exposée du palet, de sorte à former chacune parmi la piste métallique de connexion électrique et la piste métallique de masse, en remplissant chaque via formé, et
- une formation de pads d'entrée/sortie du module frontal sur le deuxième niveau métallique de connexion électrique.

Selon une troisième variante, le procédé peut comprendre en outre :
- un dépôt d'un des premier et deuxième niveaux métalliques de connexion électrique sur le premier substrat porteur, de sorte à présenter au moins deux parties électriquement disjointes entre elles, chacune de ces deux parties constituant une partie de l'une parmi la piste métallique de connexion électrique et la piste métallique de masse,
- un report du palet sur une partie du niveau métallique précédemment déposé, cette partie constituant une partie de la piste métallique de connexion électrique,
- une formation d'un pilier métallique de connexion électrique sur chacune de deux parties électriquement disjointes entre elles du niveau métallique précédemment déposé, chaque pilier métallique présentant de préférence une hauteur supérieure à une épaisseur du palet entre ses surfaces principales,
- un dépôt de l'un parmi le premier matériau diélectrique et le deuxième matériau diélectrique sur le niveau métallique de connexion électrique précédemment déposé et au moins autour du palet,
- un dépôt d'un autre des deux niveaux métalliques de connexion électrique sur le matériau diélectrique précédemment déposé, une surface principale exposée du palet et le sommet de chacun pilier métallique, de sorte à former chacune parmi la piste métallique de connexion électrique et la piste métallique de masse,
- un report du circuit intégré radiofréquence par sa face avant sur l'autre des deux niveaux métalliques de connexion électrique, de sorte à contacter électriquement chacune des deux pistes métalliques de connexion électrique,
- un dépôt de l'autre parmi le premier matériau diélectrique et le deuxième matériau diélectrique sur l'autre des deux niveaux métalliques de connexion électrique au moins autour du circuit intégré radiofréquence,
pour obtenir, sur le premier substrat porteur, une première partie du module frontal,
- un transfert de la première partie du module frontal depuis le premier substrat porteur sur le second substrat porteur par la face de la première partie du module frontal opposée à celle par laquelle la première partie du module frontal repose sur le premier substrat support,
de sorte que la première partie du module frontal puisse être traitée depuis sa surface exposée après son transfert, pour finir de former le module frontal, puis
- une formation de pads d'entrée/sortie du module frontal sur le premier niveau métallique de connexion électrique.

Selon un exemple, le procédé peut comprendre en outre, après assemblage du circuit intégré radiofréquence et du palet :
- le retrait du second substrat porteur.

On entend par un élément à base d'un matériau A, un élément comprenant ce matériau A et éventuellement d'autres matériaux.

On entend par « matériau magnétique auto-polarisé », ou de façon équivalente « matériau magnétique sans aimant », un matériau présentant une anisotropie magnétique uniaxiale élevée (avec par exemple Ha > 20 Oe), un champ coercitif élevé (par exemple supérieure à 4000 Oe) et une aimantation à saturation élevée (par exemple supérieure à 4 kG). Ces propriétés conduisent à une magnétisation rémanente élevée qui assure la nature auto-polarisée du matériau. Les principaux matériaux magnétiques utilisés pour constituer en partie un circulateur sont par exemple choisis parmi les hexaferrites, tels que les hexaferrites de baryum, les hexaferrites de strontium et les hexaferrites dopés au lanthane et au cobalt, et les nanocomposites magnétiques, tels que les nanofils à base d'un alliage de fer et de nickel et ceux à base d'un alliage de fer et de cobalt. Ledit matériau peut être magnétisé selon une direction donnée en utilisant un champ magnétique externe, par exemple généré par un aimant permanent puissant, soit pendant une phase de préparation du matériau, soit pendant un dépôt d'un film de ferrite et une phase d'intégration.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'un premier élément sur un deuxième élément, ne signifie pas obligatoirement que les deux éléments sont directement au contact l'un de l'autre, mais signifie que le premier élément recouvre au moins partiellement le deuxième élément en étant soit directement à son contact, soit en en étant séparé par au moins un autre élément.

On entend par « couche de redistribution », plus connue sous l'acronyme RDL (pour « redistribution layer » selon la terminologie anglo-saxonne) une couche structurée et configurée pour rendre des pads d'entrée/sortie d'un circuit intégré disponibles à d'autres emplacements d'un assemblage microélectronique, assurant ainsi un meilleur accès aux pads si nécessaire. Une telle couche de redistribution RDL comprend ainsi des pistes métalliques sur un ou plusieurs niveaux séparés par un matériau isolant et reliées par des vias conducteurs métalliques. La notion de RDL est classiquement utilisée pour désigner les interconnexions métalliques réalisées dans un procédé de conditionnement (de l'anglais « packaging ») visant à préparer un module électronique comprenant une ou plusieurs puces (de l'anglais « chip ») et éventuellement d'autres composants électroniques.

On notera qu'il existe plusieurs types de conditionnement et de procédés associés. Dans la présente demande, les procédés décrits utilisent tous une technique de type FOWLP, pour « Fan-Out Wafer-Level Packaging » selon la terminologie anglo-saxonne. Un procédé FOWLP est un procédé de conditionnement « qui s'étale en dehors, ou au-delà, d'une puce ou plus généralement d'un composant » que l'on souhaite conditionner, ou « emballer ». Ainsi, le résultat d'un procédé FOWLP est tel que la puce emballée est entourée latéralement d'un matériau isolant. Le procédé FOWLP est ainsi « l'inverse » d'un procédé FIWLP « Fan-In Wafer-Level Packaging » dans lequel la puce n'est pas recouverte latéralement d'un isolant, mais sera uniquement conditionnée sur le dessus et/ou le dessous.

Une fois le module réalisé, par des procédés de conditionnement du type FOWLP, on obtient un module qui présente une face avant, ou « front side » selon la terminologie anglo-saxonne, et une face arrière, ou « back side » selon la terminologie anglo-saxonne. Les éléments, types puces, présents dans le module sont reliés, par des pistes métalliques de la RDL, à des plots de connexion externes présents sur la face avant et/ou la face arrière du module.

On entend par un « BEOL », pour « back end of line » selon la terminologie anglo-saxonne), une partie interne d'un circuit intégré, ou puce, qui se compose de pistes conductrices réalisés sur *n* niveaux métalliques et interconnectées par des vias métalliques noyés dans un matériau diélectrique, en général un oxyde. Cette partie BEOL est réalisée sur une partie FEOL (« Front End of line » selon la terminologie anglo-saxonne) qui comprend un substrat semi-conducteur dans et au-dessus duquel sont réalisés des composants électroniques, par exemple des transistors.

Ainsi, une couche de redistribution RDL et un BEOL ont en commun d'avoir des pistes métalliques sur plusieurs niveaux et interconnectés par des vias. Néanmoins, RDL et BEOL se réfèrent à des procédés de fabrication différents. On parle de BEOL quand on est dans un procédé de fabrication de puces électroniques incluant une ou plusieurs couches semiconductrices constituant un FEOL, le BEOL correspondant aux dernières étapes de fabrication. On parle de couche(s) de redistribution RDL quand on est dans une phase d'emballage, ou de conditionnement, d'une ou plusieurs puces. La RDL peut être réalisée avant, ou après, report d'une puce électronique, comme cela sera illustrée dans les exemples ci-après.

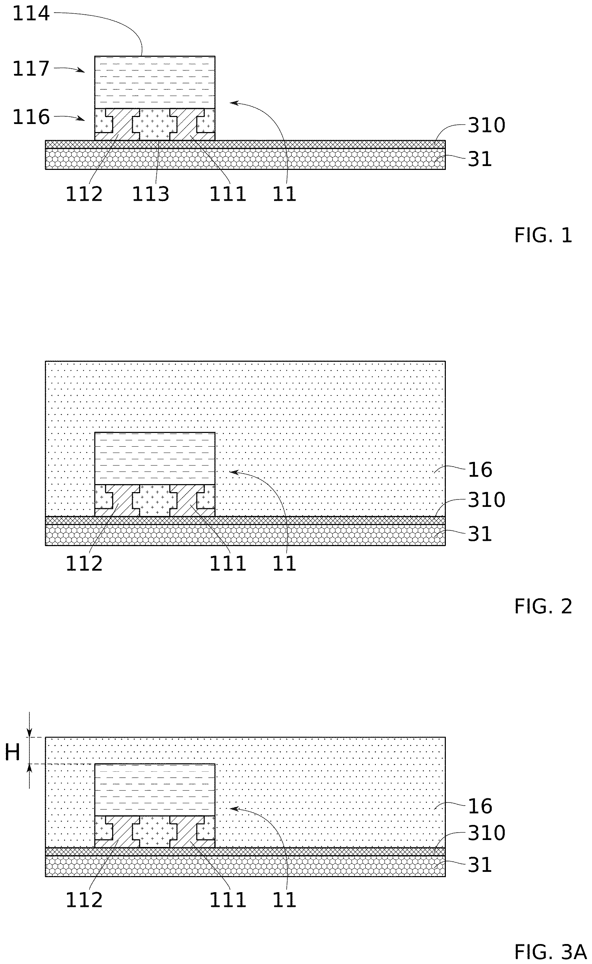

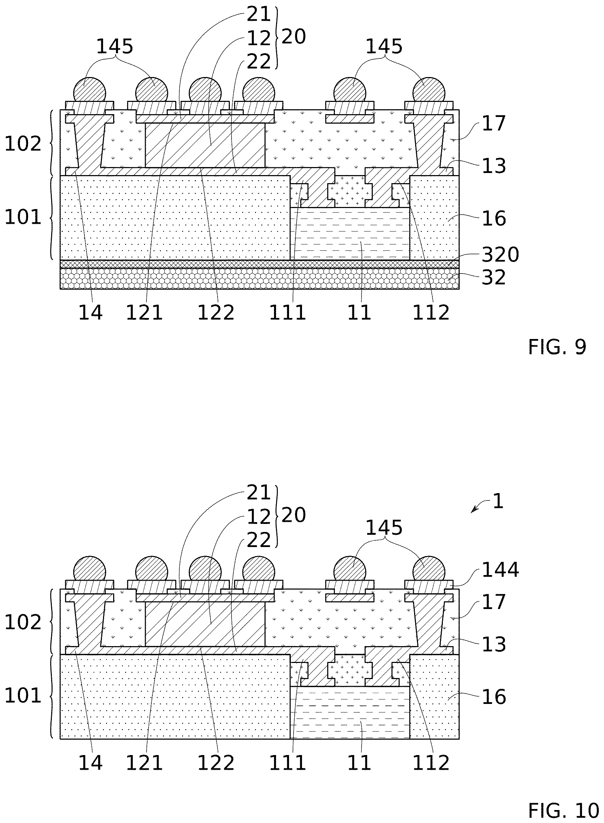

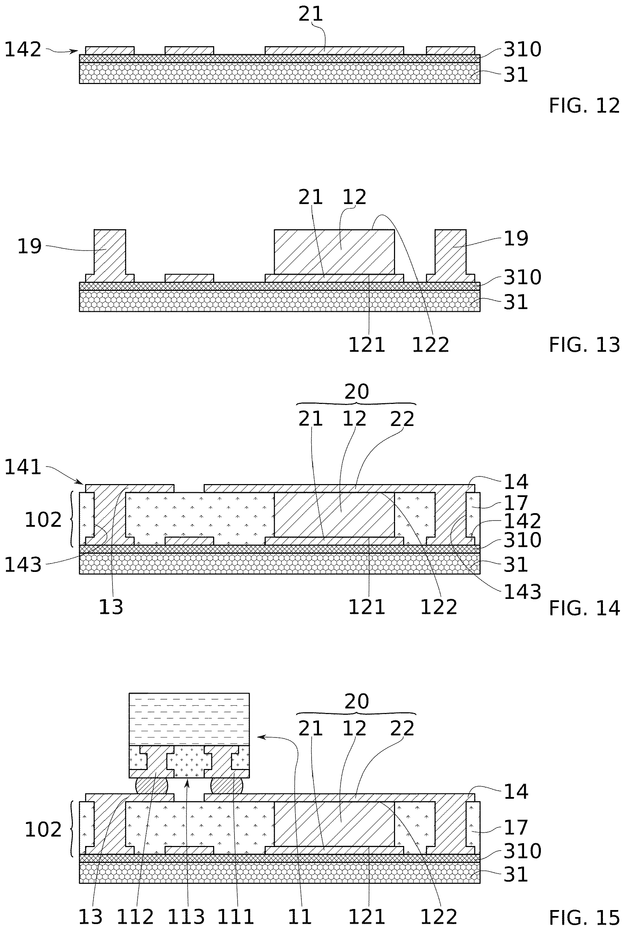

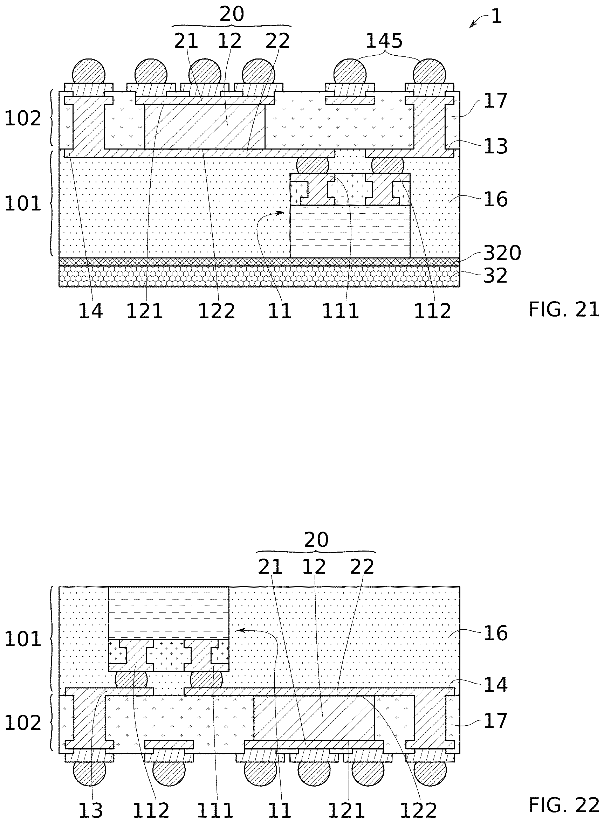

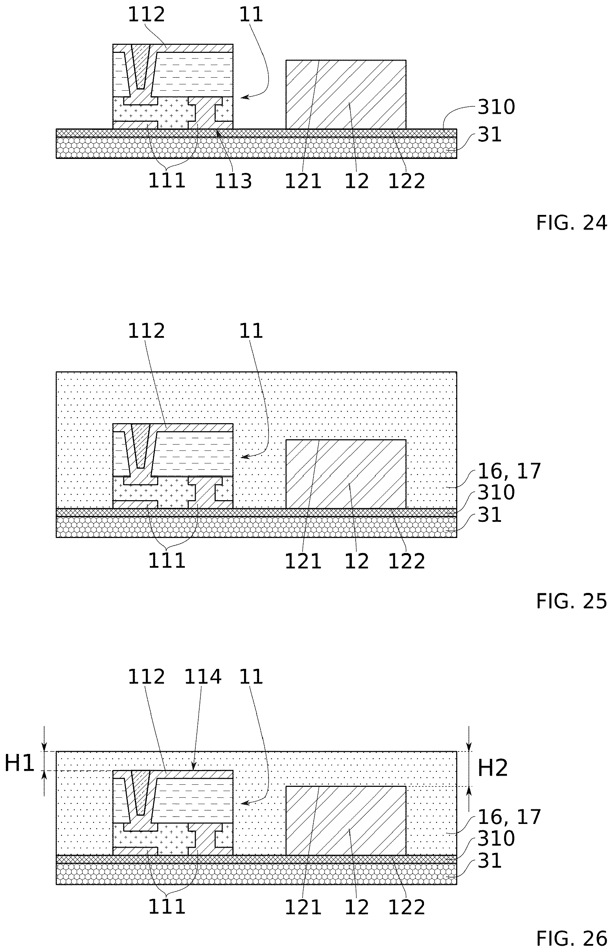

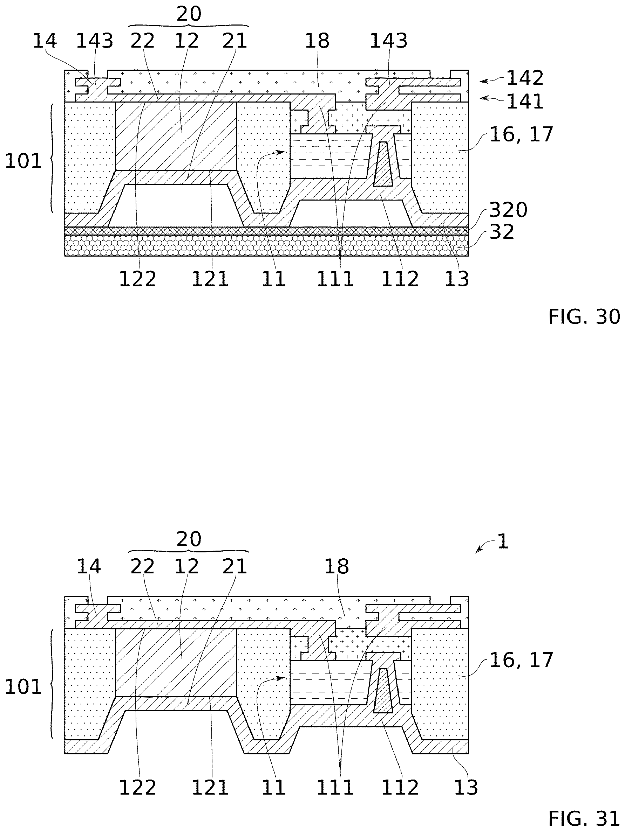

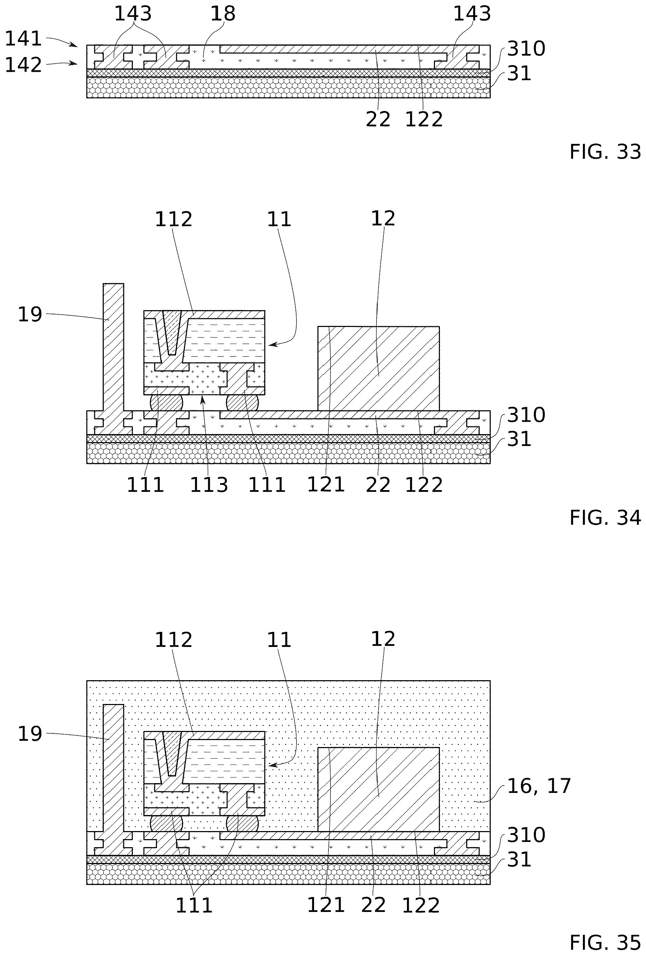

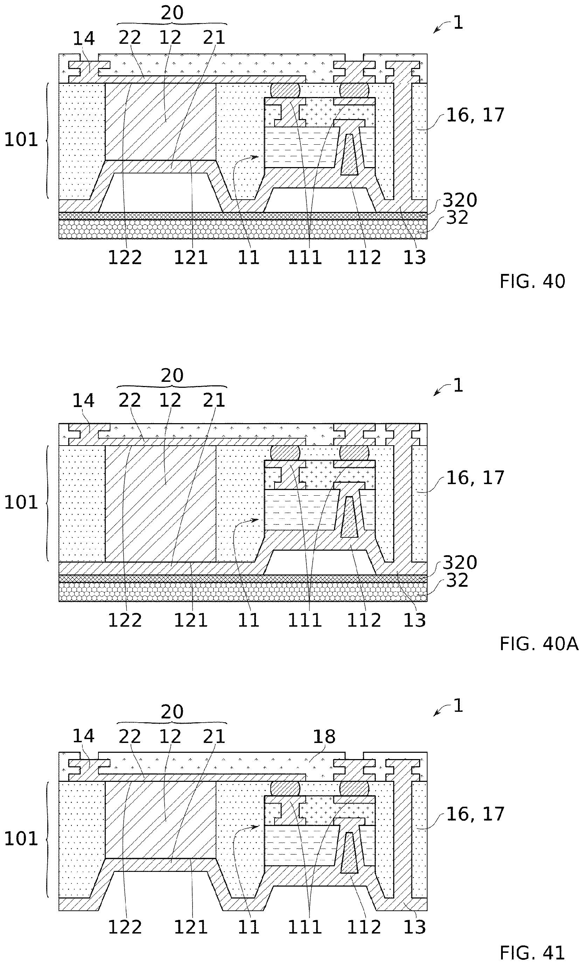

Les figures 10 et 22 illustrent chacune une vue en coupe de deux modes de réalisation du module frontal 1 similaires dans leur agencement à deux niveaux, et obtenus respectivement par un procédé de fabrication dit « Die first » (illustré par les figures 1 à 9) et par un procédé de fabrication dit « RDL first » (illustré par les figures 13 à 21). Les figures 31 et 41 illustrent chacune une vue en coupe de deux modes de réalisation du module frontal 1 similaires dans leur agencement à un unique niveau, et obtenus respectivement par un procédé de fabrication dit « Die first » (illustré par les figures 24 à 30) et par un procédé de fabrication dit « RDL first » (illustré par les figures 33 à 40-40A). Les différents modes de réalisation du module frontal RF selon l'invention et de mise en oeuvre du procédé de fabrication selon l'invention sont décrits ci-dessous séquentiellement.

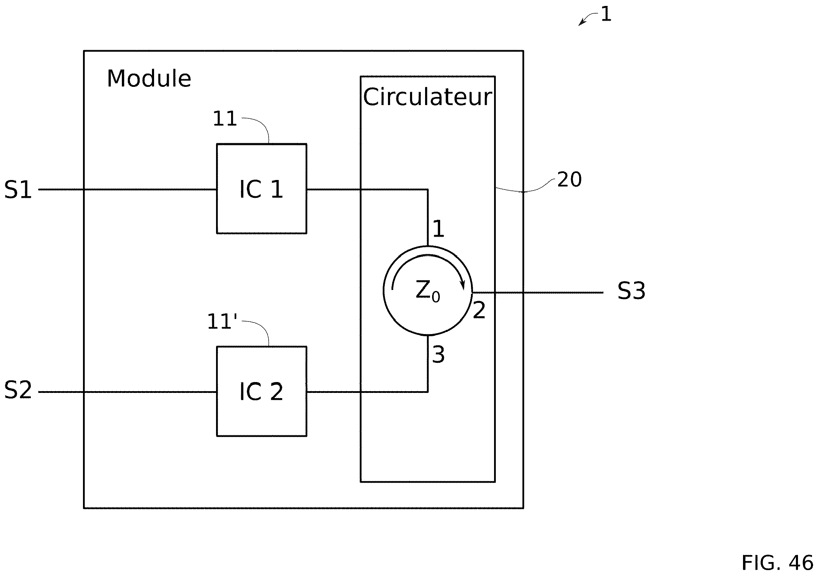

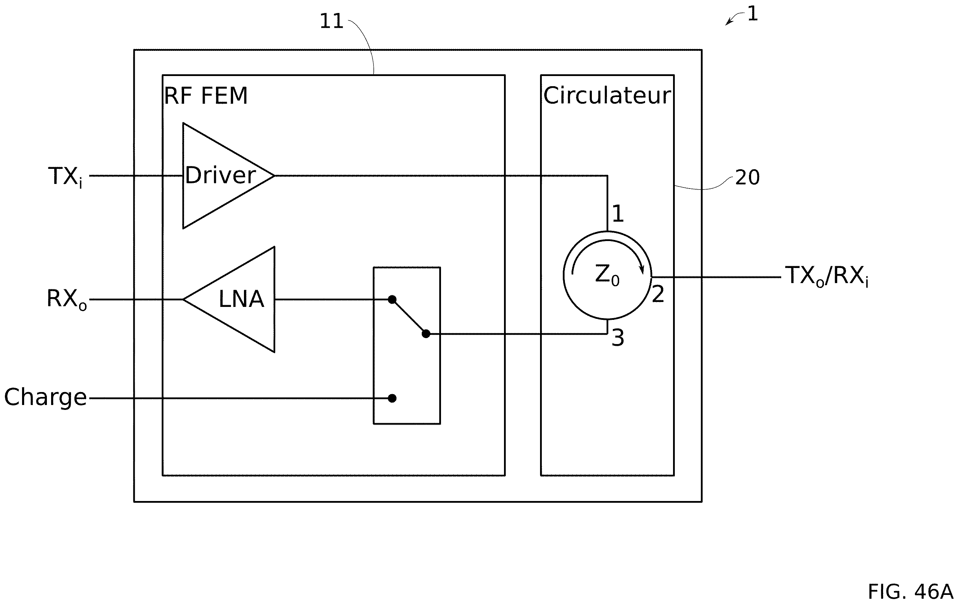

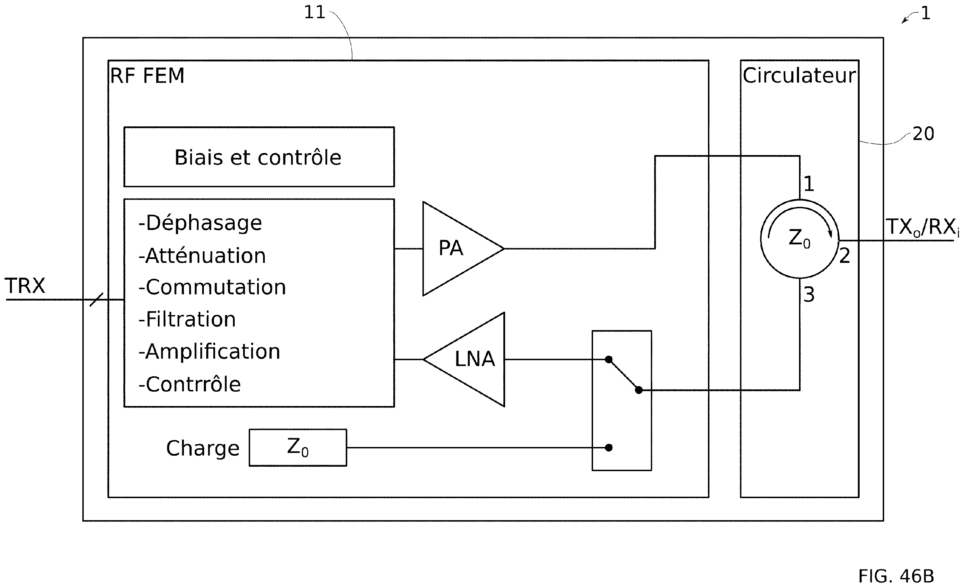

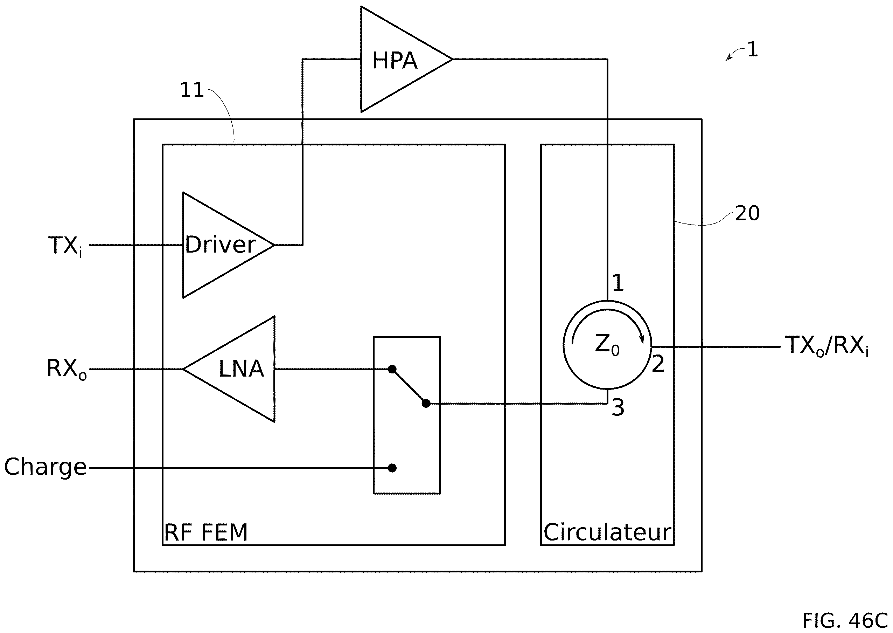

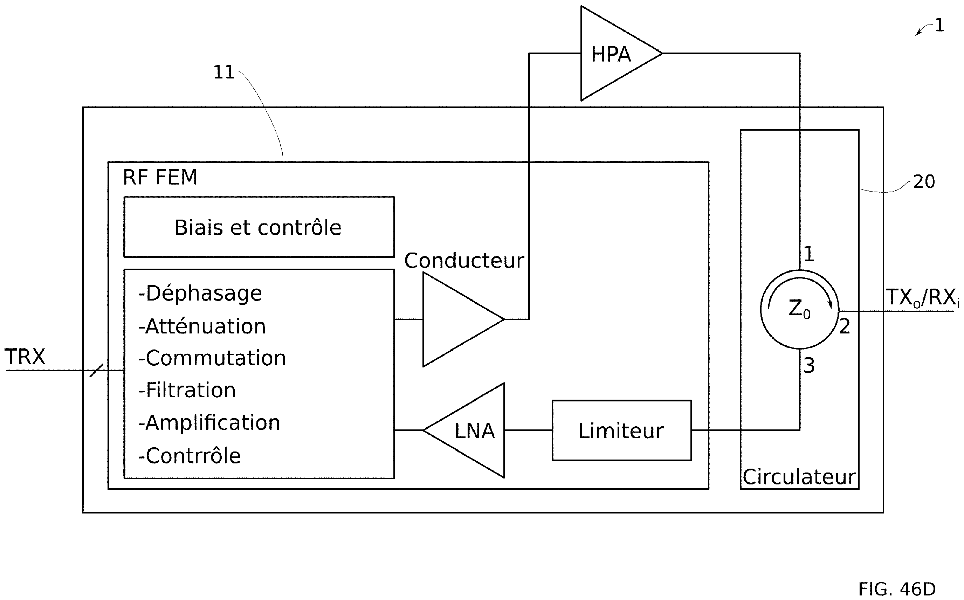

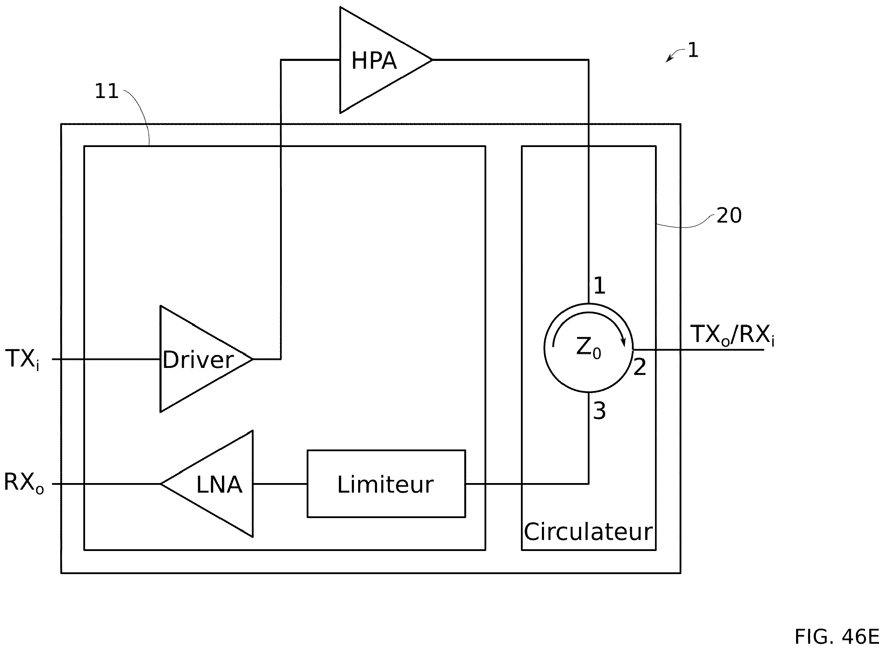

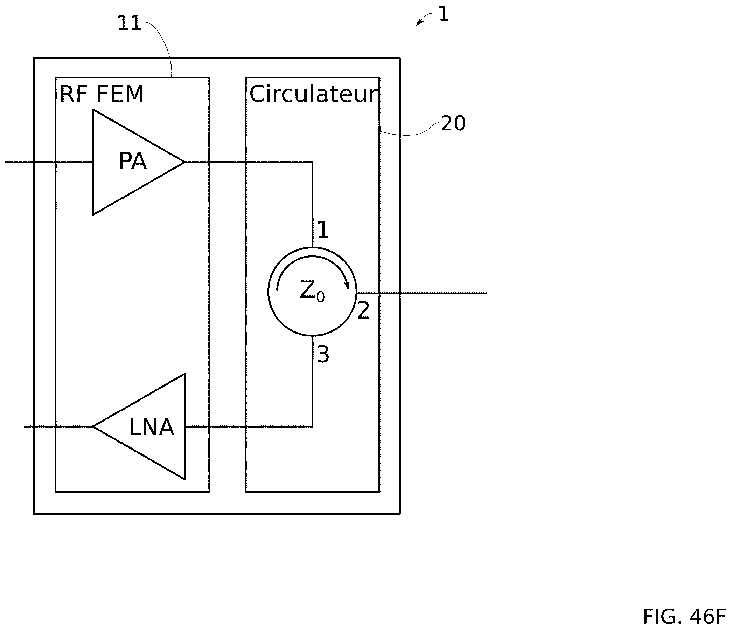

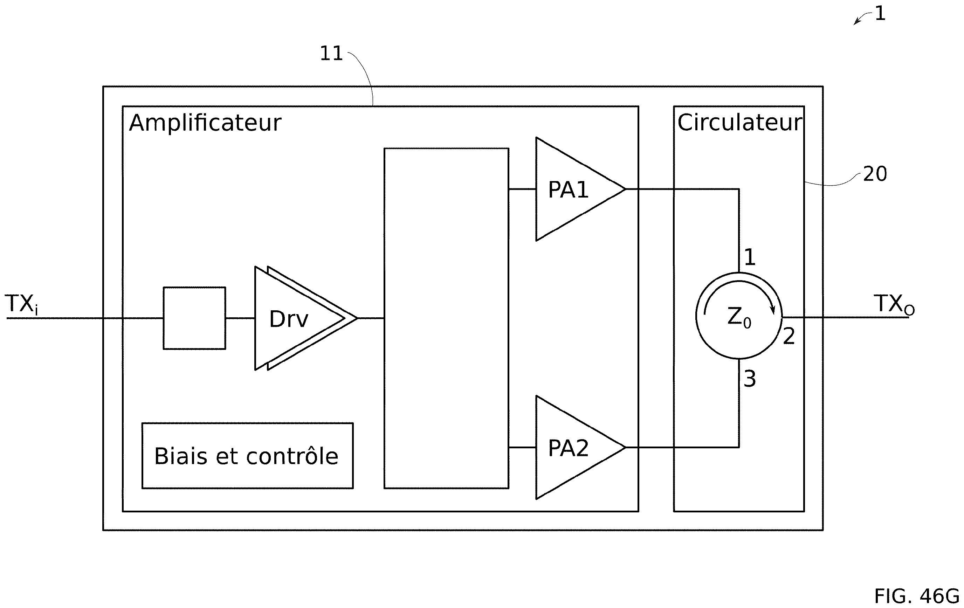

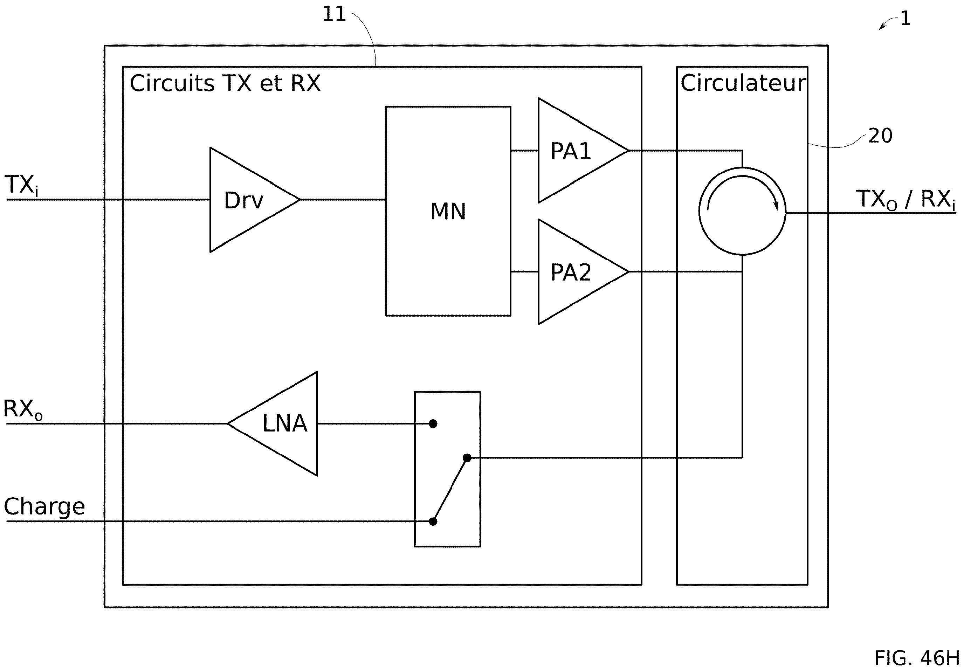

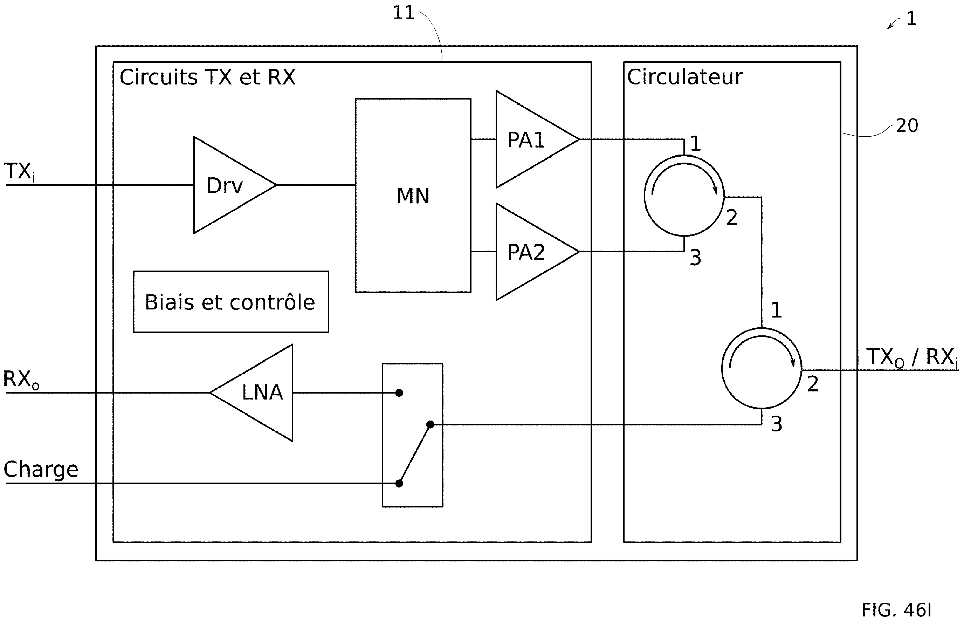

Notons tout d'abord que chacun des différents modes de réalisation illustrés sur les figures 10, 22, 31 et 41 comprend un circuit intégré radiofréquence 11. Plus particulièrement, chaque mode de réalisation d'un module frontal RF selon l'invention peut comprendre un ou plusieurs circuits intégrés radiofréquence 11, 11', etc., comme cela est notamment illustré sur la figure 46.

Chaque circuit intégré radiofréquence comprend au moins deux zones de connexion électrique 111, 112 dont une zone de connexion « signal » 111 destinée à recevoir un signal, c'est-à-dire autre chose qu'une tension fixe telle que la masse ou une tension d'alimentation, et une zone de connexion à la masse 112 C'est par ces zones de connexion électrique 111, 112 que le circuit intégré radiofréquence 11 est destiné à être connecté à un autre élément du module frontal 1 et/ou à un élément extérieur au module frontal 1.

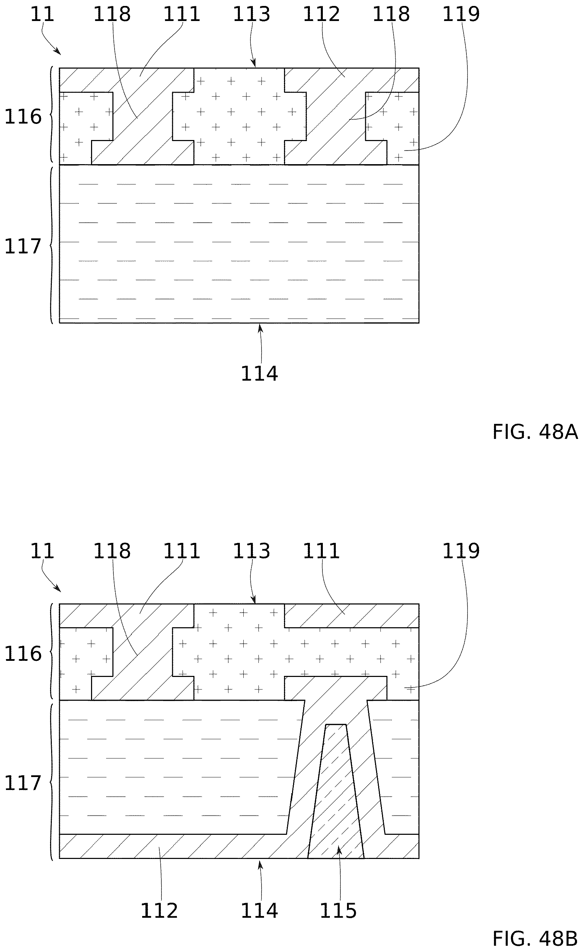

Des schémas simplifiés de tels circuits intégrés radiofréquence 11 sont illustrés aux figures 48A et 48B. En référence à ces figures, mais de manière connue en soi, chaque circuit intégré radiofréquence 11 peut comprendre deux parties 116 et 117 superposées entre elles successivement depuis une face avant 113 jusqu'à une face arrière 114 du circuit : une première partie 116 de BEOL et une deuxième partie 117 de FEOL.

La première partie 116 de BEOL se compose d'au moins un niveau métallique, et généralement de plusieurs niveaux métalliques. Sur les figures 48A à 48B, la première partie 116 comprend deux niveaux métalliques, le deuxième niveau métallique étant situé en face avant 113 de chaque circuit 11 constituant le cas échéant une ou plusieurs zones de connexion électrique, par lesquels entrent et sortent les signaux, et le premier niveau métallique assurant une connexion électrique fonctionnelle avec la deuxième partie 117 de FEOL du circuit 11. Les différents niveaux métalliques de la première partie 116 de chaque circuit 11 sont potentiellement interconnectés entre eux par des vias métalliques 118 traversant un matériau diélectrique 119, en particulier un oxyde, et par exemple un oxyde du matériau semi-conducteur à base duquel est constitué la deuxième partie 117 du circuit 11. Dans la première partie 116 de chaque circuit 11 peuvent être intégrés les éléments passifs (inductances, capacités, etc.) du circuit 11.

Le substrat semi-conducteur de la deuxième partie 117 de chaque circuit 11 comprend généralement les parties d'un circuit intégré radiofréquence que l'on nomme 'actives', telles que les transistors (non représentés sur les schémas simplifiés), ainsi que, dans certaines technologies telles que celle illustrée sur la figure 48B, des vias 115 à travers le silicium, plus connus sous l'acronyme TSV (pour « Through-Silicon Vias » selon la terminologie anglo-saxonne). La technologie TSV permet notamment une liaison métallique entre le premier niveau métallique de la première partie 116, qui est le plus près de la deuxième partie 117, et la face arrière 114 du circuit intégré 11. De telles liaisons métalliques sont majoritairement utilisées pour des connexions à la masse, ou à une alimentation, et éventuellement pour la transmission de signaux. C'est pourquoi, contrairement au cas illustré sur la figure 48A, la zone de connexion à la masse 112 est située, dans le cas illustré sur la figure 48B, en face arrière 114 du circuit 11. Notons que les schémas des figures 48A et 48B sont non seulement simplifiés, mais sont en outre des vues en coupe dans un circuit intégré radiofréquence 11. Notamment, de telles vues peuvent être trompeuses en ce que les circuits intégrés radiofréquence comprennent généralement bien davantage que deux ou trois zones de connexion électrique.

Notons également que chacun des différents modes de réalisation illustrés sur les figures 10, 22, 31 et 41 comprend en outre un palet 12 à base d'un matériau magnétique auto-polarisé, par exemple à base de l'un au moins parmi : une ferrite et une hexaferrite. Le palet 12 présente une première surface principale 121 et une deuxième surface principale 122 opposée à la première surface principale 121.

Chacun des différents modes de réalisation illustrés sur les figures 10, 22, 31 et 41 comprend encore :
- un premier matériau diélectrique 16 et un deuxième matériau diélectrique 17, formant une couche d'enrobage latéral respective du circuit intégré radiofréquence 11 et du palet 12 en les maintenant mécaniquement en position relative l'un par rapport à l'autre, et
- une couche de redistribution RDL de connexions électriques placée au-dessus de la couche d'enrobage comprenant ledit premier matériau diélectrique 16 ; la couche de redistribution RDL comprend une piste métallique de connexion électrique de signal 14 reliant la deuxième surface principale 122 du palet 12 et ladite première zone de connexion électrique 111 du circuit intégré pour permettre la transmission d'un signal électrique entre le palet 12 et le circuit intégré 11.

Plus particulièrement, chacun des différents modes de réalisation illustrés sur les figures 10, 22, 31 et 41 peut comprendre au moins une piste métallique de connexion à la masse 13 et une piste métallique de connexion électrique dite de « signal » 14, les pistes métalliques 13 et 14 étant électriquement disjointes entre elles, du moins au sein du module frontal 1. Chacune des pistes métalliques 13 et 14 peut être réalisée sur un ou plusieurs niveaux métalliques de la couche de redistribution RDL et/ou réalisées sur un niveau ou une couche métallique dédiée notamment pour la piste 13 destinée à être reliée à la masse.

Les modes de réalisation illustrés sur les figures 10 et 22 comprennent le deuxième matériau diélectrique 17 susmentionné. Plus particulièrement, le premier matériau diélectrique 16 forme une couche d'enrobage latéral du circuit intégré radiofréquence 11 et le deuxième matériau diélectrique 17 forme une couche d'enrobage latéral du palet 12.

Dans les modes de réalisation illustrés sur les figures 31 et 41, le premier matériau diélectrique 16 et le deuxième matériau diélectrique 17 sont en fait confondus, ou autrement dit, ils constituent un même matériau diélectrique (référencé « 16, 17 »).

Par ailleurs, chacun des différents modes de réalisation illustrés sur les figures 10, 22, 31 et 41 est tel que le premier matériau diélectrique 16 et le deuxième matériau diélectrique 17 maintiennent mécaniquement au moins le circuit intégré radiofréquence 11 et le palet 12 en position relative l'un par rapport à l'autre, à l'intérieur du module frontal, dans un même assemblage obtenu par un procédé de conditionnement utilisant un procédé FOWLP.

Les pistes métalliques de connexion électrique 13, 14 peuvent également être considérées comme au moins en partie maintenues mécaniquement par le ou les matériaux diélectriques utilisés, dans l'assemblage réalisé pour former le module frontal. Par exemple, les pistes métalliques peuvent avoir été déposées sur un des matériaux diélectriques, servant alors de support de dépôt, puis recouvertes le cas échéant d'un des matériaux diélectriques, pour se retrouver encapsuler dans les matériaux diélectriques. En outre, chacune des pistes métalliques de connexion électrique 13, 14 peut présenter une géométrie tridimensionnelle et/ou au moins deux niveaux métalliques de connexion électrique 141, 142 interconnectés entre eux par l'intermédiaire de vias métalliques 143 dans la couche de redistribution RDL. En alternative, les différents niveaux métalliques de connexion électrique peuvent être interconnectés entre eux par une technologie de fabrication du type « conformal » telle que l'une de celles connues sous la référence WLP. Une telle technologie de fabrication pourra notamment être privilégiée lorsque le palet 12 présente une épaisseur relativement faible, par exemple une épaisseur comprise entre 5 et 10 microns. Au contraire, lorsque le palet 12 présente une épaisseur relativement élevée, une technologie de fabrication des différents niveaux métalliques de connexion électrique par des vias 143 à travers un troisième matériau diélectrique 18 (Cf. par exemple figures 31 et 41) et/ou par des piliers (Cf. par exemple figure 41) pourra être à privilégier.

Mais encore, chacun des différents modes de réalisation illustrés sur les figures 10, 22, 31 et 41 peut être tel que :
- une zone métallique de masse 21 s'étend sur la première surface principale 121 du palet 12, ; et
- une zone métallique de signal 22 s'étend sur la deuxième surface principale 122 du palet 12.

Il est alors possible que la piste métallique de connexion électrique de signal 14 relie la deuxième surface principale 122 du palet 12 et ladite première zone de connexion électrique 111 du circuit intégré pour permettre la transmission d'un signal électrique entre le palet 12 et le circuit intégré 11, au moins par la zone métallique de signal 22.

Chacun des modes de réalisation peut comprendre ainsi un composant magnétique 20 du module frontal 1 qui peut être formé au moins par le palet 12 en un matériau magnétique, la zone métallique de masse 21 et la zone métallique de signal 22. Une ou plusieurs couches peuvent être prévues entre le palet 12 en un matériau magnétique et l'une et/ou l'autre des zones métalliques 21 et 22. Le composant magnétique 20 peut constituer ou comprendre au moins l'un parmi un circulateur, un gyrateur et un isolateur.

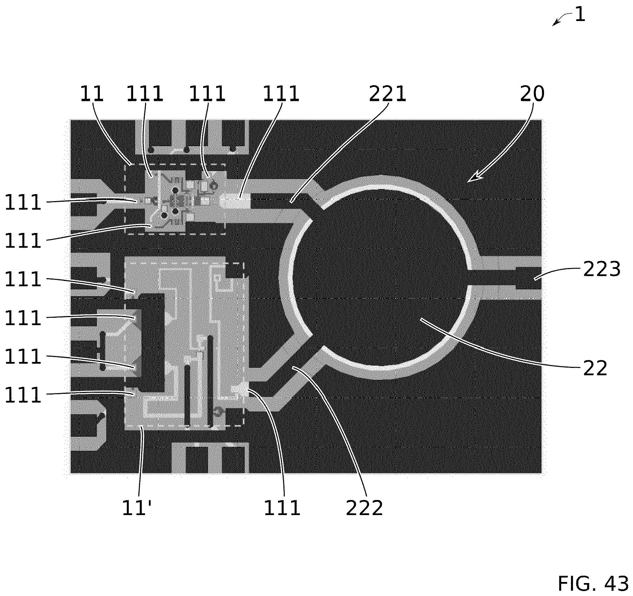

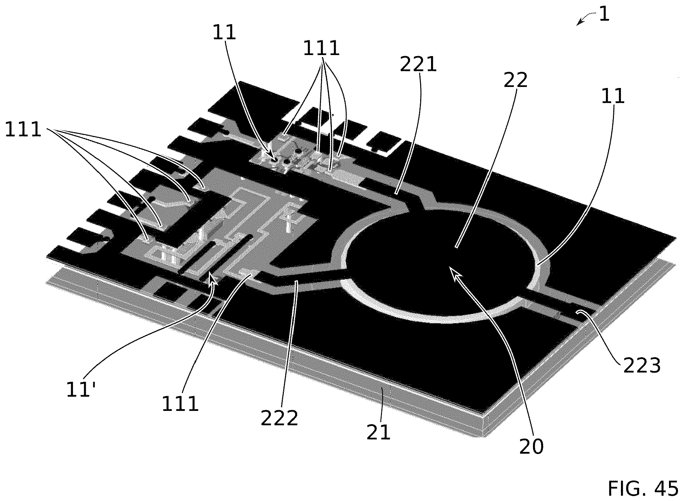

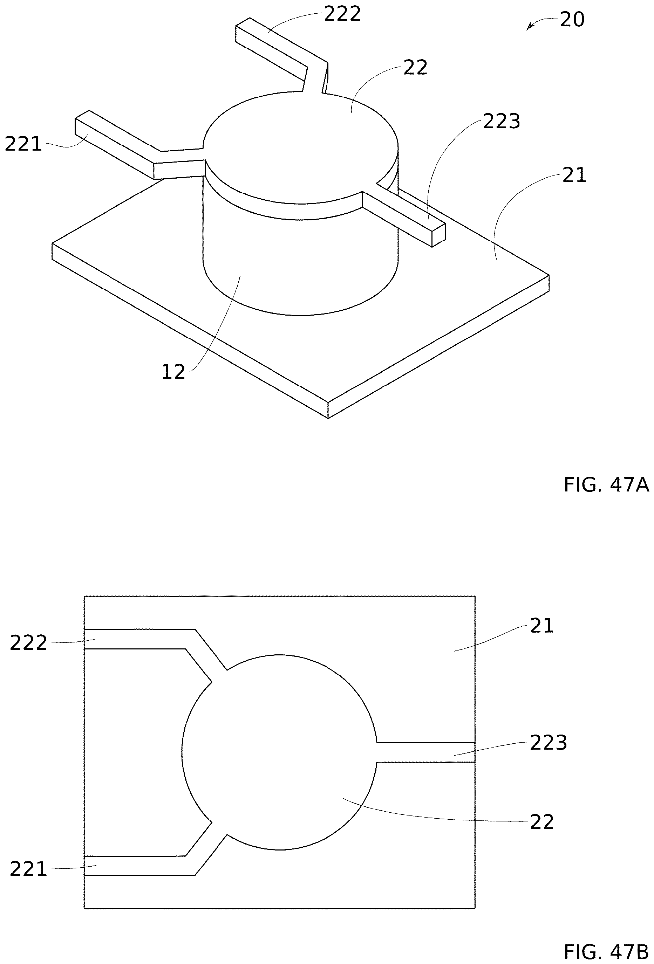

Un circulateur, en tant que composant magnétique 20, est illustré sur les figures 47A et 47B. On y retrouve référencés les différents éléments susmentionnés d'un composant magnétique 20 intégré dans un module frontal 1 selon l'invention. Notons que le circulateur illustré comprend trois pattes d'entrée/sortie 221, 222 et 223, comme c'est le cas ordinairement. Au moins l'une de ses pattes d'entrée/sortie est destinée à être en connexion électrique avec une zone métallique de connexion électrique « signal » du circuit intégré 11. Cette connexion électrique « signal » est réalisée à l'intérieur du module frontal 1 selon l'invention. Cela est particulièrement bien illustré sur les figures 43 et 45, où l'on observe clairement que la patte 221 est reliée au circuit intégré 11 et la patte 222 est relié au circuit intégré 11'.

En alternative ou en complément à ce qui précède, chacun des différents modes de réalisation du module frontal 1 selon l'invention peut en outre être tel que :
- une première piste métallique de connexion électrique de masse 13 est en contact avec la zone de connexion à la masse 112 du circuit intégré radiofréquence 11, cette première piste 13 étant éventuellement également en contact avec la zone métallique de masse 21 accolée au palet 12 (cas des modes de réalisation à un seul niveau de matériau diélectriques 16,17) et
- une deuxième piste métallique de connexion électrique signal 14 est en contact avec au moins une zone de connexion électrique signal 111 du circuit intégré radiofréquence 11 différente de la zone de connexion à la masse 112, et est en contact avec la zone de connexion électrique signal 21 accolée au palet 12.

On notera que, dans les modes de réalisation illustrés sur les figures 31 et 41, le module frontal 1 est tel que le premier matériau diélectrique 16 et le deuxième matériau diélectrique 17 s'étendent sur un même niveau 101 du module frontal 1 en formant une couche dans laquelle le circuit intégré radiofréquence 11 et le palet 12 sont intégrés, le cas échéant le premier matériau diélectrique 16 et le deuxième matériau diélectrique 17 étant confondus entre eux. L'épaisseur du module frontal RF selon ces modes de réalisation est ainsi avantageusement réduite. En outre, les modules frontaux 1 sont ainsi compatibles avec des palets 12 de différentes épaisseurs, couvrant ainsi potentiellement une large variété de gammes de fréquence d'application et de puissance. De plus, les modules frontaux 1 présentent ainsi une bonne dissipation thermique qui les rend adaptés à des applications à forte puissance car le plan de masse agit comme un bon radiateur. Comme cela apparaîtra au vu de la description détaillée des exemples de mise en oeuvre du procédé de fabrication d'un module frontal RF selon l'invention, ils sont avantageusement compatibles avec une intégration d'antenne selon une technologie d'intégration FOWLP et/ou selon une technologie d'intégration tridimensionnelle (aussi connue sous l'appellation « 3D integration/assembly » selon la terminologie anglo-saxonne).

Dans les modes de réalisation illustrés sur les figures 10 et 22, le premier matériau diélectrique 16 s'étend sur un premier niveau 101 du module frontal 1 en formant une première couche dans laquelle le circuit intégré radiofréquence 11 est intégré et le deuxième matériau diélectrique 17 s'étend sur un deuxième niveau 102 du module frontal 1 en formant une deuxième couche dans laquelle le palet 12 est intégré. La première couche et la deuxième couche sont distinctes entre elles, et superposées. Le premier matériau diélectrique 16 et le deuxième matériau diélectrique 17 peuvent être de même nature ou de natures différentes. Le module frontal RF offre ainsi une grande variété d'adaptation de la position du circuit intégré radiofréquence 11 relativement à la position du composant magnétique 20. Notons d'ailleurs ici que, si les modes de réalisation illustrés sur les figures 10 et 22 sont tels que le circuit intégré radiofréquence 11 et le composant magnétique 20 ne sont pas l'un au-dessus de l'autre, ce cas est tout de même envisageable.

Il apparaît, au vu de ce qui précède, que l'épaisseur du palet 12 entre ses surfaces principales 121, 122 peut être supérieure à une épaisseur du circuit intégré radiofréquence 11 entre sa face avant 113 et sa face arrière 114, dans chacun des modes de réalisation illustrés sur les figures 10, 22, 31 et 41. Le module frontal 1 selon l'invention montre ainsi un des principaux avantages acquis grâce à son procédé de fabrication utilisant une technique de conditionnement (packaging) de type FOWLP. Selon cet avantage, l'épaisseur du palet 12, et donc du composant magnétique 20, n'est avantageusement pas contrainte par l'épaisseur du circuit intégré radiofréquence 11, et plus particulièrement par l'épaisseur de la couche de matériau diélectrique 16 dans laquelle le circuit intégré radiofréquence 11 est intégré. Ainsi, le palet 12, et donc le composant magnétique 20, peut avoir une épaisseur supérieure à l'épaisseur du circuit intégré radiofréquence 11, ce qui est souvent souhaité notamment pour atteindre une certaine tenue en puissance du composant magnétique 20 et/ou pour améliorer l'efficacité spectrale du module frontal 1.

Comme cela ressortira clairement de la description ci-dessous des différents procédés de fabrication d'un module frontal 1 selon l'invention, nul adhésif ou mastic de remplissage, tel qu'une résine époxy non-conductrice, n'est nécessaire, notamment autour de parois latérales du palet 12, pour stabiliser les performances du module frontal 1 relativement aux fréquences et aux températures de son fonctionnement ou son usage, y compris dans des conditions de fortes vibrations.

En outre, il n'est pas non plus nécessaire d'utiliser un aimant externe (souvent très encombrant) pour réaliser la fonction magnétique, et en particulier celle de circulateur. Le composant magnétique 20 tel que décrit ci-dessus étant auto-polarisé y suffit.

Nous décrivons ci-dessous les différents modes de mise en oeuvre du procédé de fabrication selon l'invention.

En référence aux figures 1 à 9, nous décrivons ci-dessous un mode de mise en oeuvre d'un procédé de fabrication permettant d'obtenir le module frontal 1 qui est illustré sur la figure 10.

Comme illustré sur la figure 1, il est tout d'abord fourni un circuit intégré radiofréquence 11 et un premier substrat porteur 31. Le premier substrat porteur peut comprendre une couche de liaison temporaire 310 (ou « Temporary bonding layer » selon la terminologie anglo-saxonne). Le circuit intégré radiofréquence 11 est reporté, par sa face avant 113, sur le premier substrat porteur 31, et plus particulièrement sur la couche de liaison temporaire 310.

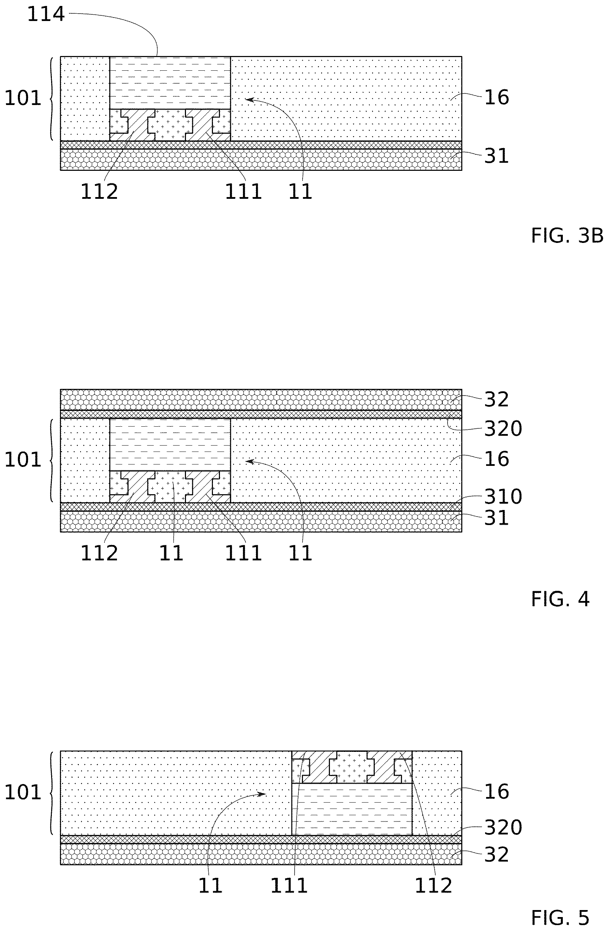

Comme illustré sur la figure 2, un premier matériau diélectrique 16 est ensuite déposé sur le premier substrat porteur 31, autour, voire également au-dessus, du circuit intégré radiofréquence 11. Ce dépôt peut consister en une croissance d'oxyde. Cette étape a pour effet de figer la position du circuit intégré radiofréquence 11 dans le premier matériau diélectrique 16. Dans le cas d'un surmoulage (ou « over molding » selon la terminologie anglo-saxonne), l'épaisseur par laquelle le premier matériau diélectrique 16 recouvre alors éventuellement la face arrière 114 du circuit intégré radiofréquence 11 peut alors :
- être ramenée, par exemple par meulage, a une épaisseur H désirée comme illustré sur la figure 3A ou, en alternative,
- être meulée jusqu'à mettre à jour la face arrière 114 du circuit intégré radiofréquence 11, comme illustré sur la figure 3B, voire même en meulant le circuit intégré radiofréquence 11 par sa face arrière 114, sans toutefois dégrader les fonctions de la deuxième partie 117 du circuit. Cette seconde alternative conduit donc à exposer le circuit intégré radiofréquence 11 par sa face arrière 114.

Notons qu'il est ici possible, le cas échéant, de mettre en oeuvre une technologie connue sous le sigle TMV pour permettre par exemple une reprise de contact à travers le premier matériau diélectrique 16.

Notons ici que, si les figures suivantes 4 à 10, reproduisent le cas illustré sur la figure 3B, ceci n'exclut évidemment pas que la suite ci-dessous décrite d'un premier mode de mise en oeuvre du procédé selon l'invention soit applicable au cas de figure illustré sur la figure 3A.

Il est ensuite prévu de transférer la partie déjà formée du module frontal 1 depuis le premier substrat porteur 31 jusque sur un deuxième substrat porteur 32. Le deuxième substrat porteur peut comprendre une couche de liaison temporaire 320 (ou « Temporary bonding layer » selon la terminologie anglo-saxonne). Dans l'alternative illustrée, le deuxième substrat porteur 32 s'étend, comme illustré sur la figure 4, sur le premier matériau diélectrique 16 et sur la face arrière 114 du circuit intégré RF 11. Après le retrait du premier substrat support 31, par exemple par décollage, le circuit intégré 11 repose par sa face arrière 114 sur le deuxième substrat porteur 32, sa face avant 113 présentant une zone de connexion à la masse 112 et une zone de connexion électrique « signal » 111, différente de la zone de connexion à la masse 112, qui se trouvent ainsi exposées, comme illustré sur la figure 5.

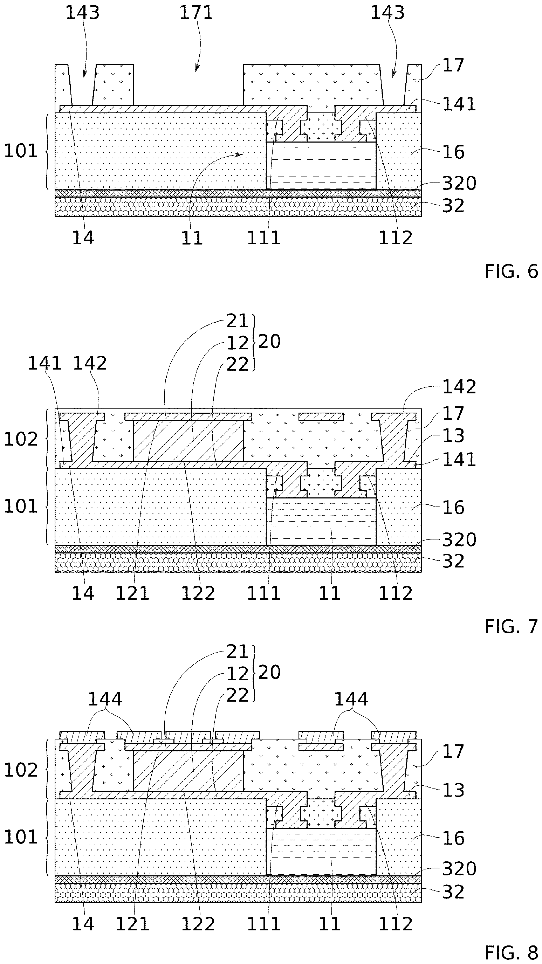

En référence à la figure 6, le procédé comprend ensuite le dépôt d'un premier niveau métallique de connexion électrique 141 de sorte à présenter deux parties électriquement disjointes entre elles, chaque partie étant destinée à constituer une partie d'une des deux pistes métalliques de connexion électrique 13 et 14 telles que décrites ci-dessus.

Toujours en référence à la figure 6, le procédé comprend ensuite le dépôt d'un deuxième matériau diélectrique 17 sur le premier niveau métallique de connexion électrique 141, et potentiellement sur toute la surface exposée de la partie du module frontal déjà fabriquée, puis une gravure du deuxième matériau diélectrique 17. Cette étape de gravure est paramétrée premièrement de sorte à former une cavité 171 située en regard de la partie du premier niveau métallique 141 ; la cavité 171 est destinée à loger le palet 12. L'étape de gravure est également paramétrée de sorte à former des vias 143 vers un deuxième niveau métallique de connexion électrique 142 (Cf. Figure 7) pour chacune des deux pistes métalliques de connexion électrique 13 et 14.

Un report du palet 12 dans la cavité 171 formée est ensuite prévu. Dès lors, la position du palet 12 relativement à celle du circuit intégré RF 11 est définie et figée. L'espacement entre le palet 12 et le circuit intégré RF 11 est ainsi contrôlé et assuré.

Puis, en référence à la figure 7, un dépôt du deuxième niveau métallique de connexion électrique 142 sur la surface du deuxième matériau diélectrique 17 et la surface principale exposée du palet 12 est réalisé, de sorte à former chacune des deux pistes métalliques de connexion électrique 13, 14, en remplissant chaque via 143 formé, par exemple selon une technique appelée en anglais « conformal layer ». Ce dépôt peut être recouvert à son tour du deuxième matériau diélectrique 17. Il apparaît ainsi, dès la figure 7, que le matériau métallique du palet 12 est inséré entre deux couches d'un réseau de redistribution, plus connues sous l'acronyme RDL (pour « redistribution layer » selon la terminologie anglo-saxonne), selon la première approche proposée (Cf. également la figure 14). Il apparaît donc que cette première approche nécessitant un minimum de deux couches de redistribution est compatible avec un palet épais ou fin, de sorte à couvrir potentiellement une large gamme d'applications en fréquence et en puissance.

S'ensuit la formation de pads d'entrée/sortie 144 du module frontal 1 sur le deuxième niveau métallique de connexion électrique 142. Cette étape peut nécessiter l'ouverture par endroits, par exemple par gravure, du deuxième matériau diélectrique 17 recouvrant éventuellement le deuxième niveau métallique de connexion électrique 142. La formation des pads 144 peut être réalisée selon une technologie connue sous l'acronyme UBM (pour « Under Bump Metallurgy » selon la terminologie anglo-saxonne).

Il est à noter ici qu'une structure à plus de deux niveaux métalliques de connexion électrique est envisageable. Ces différents niveaux métalliques de connexion électrique peuvent permettre de relier entre eux plusieurs circuits intégrés radiofréquence 11 et 11' (en fonction du schéma électrique du module frontal à fabriquer), de réaliser des fonctions passives telles que, par exemple, des inductances, des transformateurs, des isolateurs et des circulateurs, et de réaliser sur ceux-ci les différents pads d'entrée et de sortie 144 du module frontal 1. Pour un plus haut niveau d'intégration, celle d'une antenne peut également être prévue par une technologie d'intégration comparable à celle connue sous le sigle FOWLP (pour « Fan-out wafer-level packaging » selon la terminologie anglo-saxonne), par une technologie d'intégration tridimensionnelle en utilisant des vias à travers le matériau diélectrique (technologie TMV) et des options de placage supérieur (ou « top platting » selon la terminologie anglo-saxonne).

Les différents pads 144 peuvent être dédiés à des signaux radiofréquence, à des signaux de commande, à des signaux de test ou à des connexions à la masse ou à une alimentation. Il est à noter, en référence aux figures 7 et 8, que la formation des pads 144 peut nécessiter une étape antérieure d'ouverture du deuxième matériau diélectrique 17 au niveau des reprises de contact que doivent constituer les niveaux métalliques de connexion électrique, et en particulier le niveau métallique de connexion électrique situé le plus loin du deuxième substrat porteur 32. La formation des pads peut le cas échéant faire intervenir le dépôt d'une couche métallique dite UBM (pour « Under Bump Metallurgy » selon la terminologie anglo-saxonne). Chaque pad est ainsi apte à recevoir une perle de soudure 145 (ou « solder bump » selon la terminologie anglo-saxonne), par exemple à base d'un alliage d'étain et d'argent, comme illustré sur la figure 9. En alternative aux boules d'étain ou piliers en cuivre 145, de la pâte à braser peut être déposée sur les pads 144. Les deux technologies connues respectivement sous le sigle BGA (pour « Ball Grid Array » selon la terminologie anglo-saxonne) et sous le sigle LGA (pour « Land Grid Array » selon la terminologie anglo-saxonne) sont utilisables en alternative l'une de l'autre.

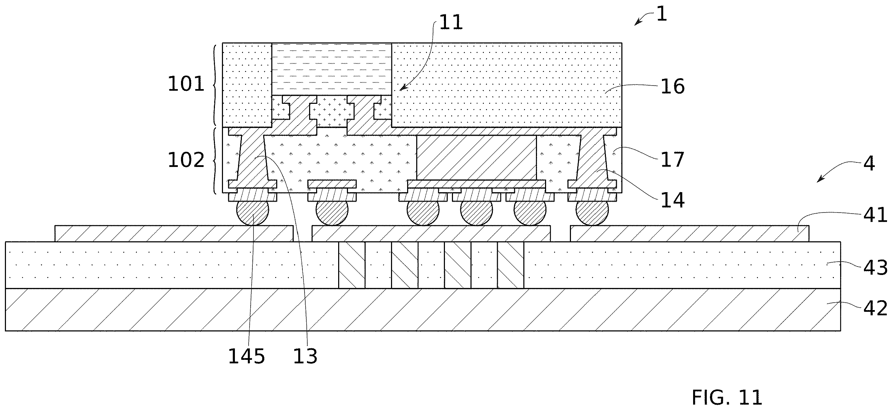

Ensuite, le retrait, par exemple par décollage, du deuxième substrat porteur 32 permet d'obtenir le module frontal 1 tel qu'illustré sur la figure 10. Le module frontal 1 est alors fabriqué et prêt à être assemblé aux autres composants d'un système radiofréquence embarquant potentiellement plusieurs modules frontaux 1 selon l'invention. Préalablement à un tel assemblage, le module frontal 1 tel qu'illustré sur la figure 10 peut être assemblé sur une carte d'évaluation 4 du module 1, par exemple de la façon illustrée sur la figure 11.

En référence à la figure 11, chaque pad 144 peut ainsi, le cas échéant par l'intermédiaire d'une boule d'étain 145 qui lui est associée, être mis en contact avec des pads 41 d'une carte d'évaluation 4 du module frontal 1, la carte d'évaluation 4 comprenant en outre, à l'opposé de ses pads 41, un plan de masse 42. La connexion du plan de masse 42 métallique de la carte d'évaluation 4 peut être réalisée via une colle conductrice ou par soudure à un alliage d'étain et d'argent, par exemple de type LGA.

Le mode de mise en oeuvre ci-dessus décrit du procédé selon l'invention relève, comme susmentionné, d'une première approche qui aboutit à une disposition du circuit intégré radiofréquence 11 et du composant magnétique 20 sur des niveaux différents entre eux du module frontal.

Un autre mode de mise en oeuvre du procédé de fabrication d'un module frontal 1 selon l'invention est décrit ci-dessous en référence aux figures 12 à 22. Il relève de la même approche, et aboutit à une même disposition par niveaux du circuit intégré radiofréquence 11 et du composant magnétique 20.

Comme illustré sur la figure 12, il est tout d'abord déposé un niveau métallique de connexion électrique 142 sur le premier substrat porteur 31, de sorte à présenter au moins deux parties électriquement disjointes entre elles, chacune constituant une partie de la couche de redistribution RDL, ou une partie d'une des deux pistes métalliques de connexion électrique 13, 14.

Puis, comme illustré sur la figure 13, le palet 12 en un matériau magnétique est reporté sur une partie du premier niveau métallique 141 constituant une partie de la couche de redistribution RDL, et plus particulièrement une partie de la première piste métallique de connexion électrique 13, celle destinée à être reliée à la masse.

La formation d'au moins un pilier métallique de connexion électrique 19 est ensuite prévue. Un pilier 19 est plus particulièrement formé sur chacune des deux parties électriquement disjointes entre elles du premier niveau métallique 141. Chacune de ces deux parties constitue une partie d'une des deux pistes métalliques de connexion électrique 13 et 14. Notons que chaque pilier métallique 19 présente de préférence une hauteur supérieure à une épaisseur du palet 12 entre ses surfaces principales 121 et 122. Les piliers 19 peuvent être soient formés par ailleurs, puis reportés, par exemple par une machine de type « pick-and-place », que ce soit avant ou après le report du palet 12, soit peuvent être formés par dépôt(s) et gravure(s) ordinaires de la micro-électronique, de préférence avant le report du palet 12.

À l'issue des deux étapes précédentes, une partie du module frontal 1 tel qu'illustré sur la figure 13 est obtenue.

En référence à la figure 14, un dépôt du deuxième matériau diélectrique 17 sur le niveau métallique de connexion électrique 142 et au moins autour du palet 12 est ensuite réalisé. Dès lors, la position du palet 12 au sein du deuxième matériau diélectrique 17 est définie et figée. Il apparaît déjà que le matériau métallique du palet 12 est inséré entre deux couches de redistribution ou RDL. Dans le cas d'un surmoulage (ou « over molding » selon la terminologie anglo-saxonne), l'épaisseur par laquelle le deuxième matériau diélectrique 17 recouvre alors éventuellement la surface principale 122 du palet 12 peut alors être meulée jusqu'à mettre à jour la surface principale 122 du palet 12. De préférence, chaque pilier métallique 19 présente une hauteur supérieure à l'épaisseur du palet 12 entre ses surfaces principales. De la sorte, le sommet de chaque pilier est exposé par l'étape de meulage susmentionnée.

Puis, toujours en référence à la figure 14, un dépôt d'un autre niveau métallique de connexion électrique 141 sur le deuxième matériau diélectrique 17 est réalisé sur une surface principale 122 exposée du palet 12 et le sommet de chaque pilier métallique 19, de sorte à former la couche de redistribution RDL ou chacune des deux pistes métalliques de connexion électrique 13 et 14.

Ensuite, comme illustré sur la figure 15, un report du circuit intégré radiofréquence 11 par sa face avant 113 sur le niveau métallique de connexion électrique 141 est réalisé, de sorte à contacter électriquement chacune des deux pistes métalliques de connexion électrique 13 et 14. Le cas échéant, chaque contact peut être réalisé via une boule d'étain (« Solder Ball ») ou un pilier en cuivre (« Copper Pillar »).

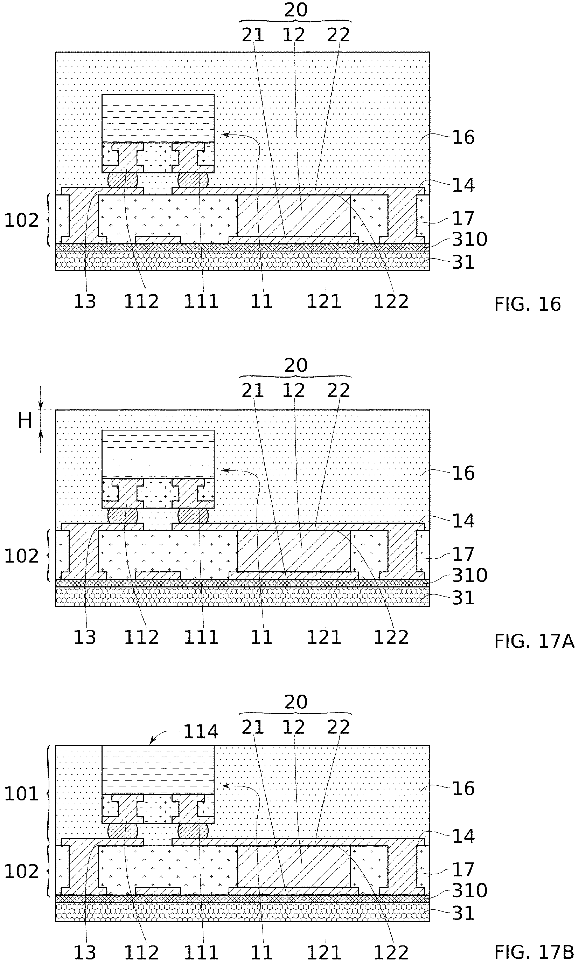

Comme illustré sur la figure 16, s'ensuit un dépôt du premier matériau diélectrique 16 sur le niveau métallique de connexion électrique 141 au moins autour du circuit intégré radiofréquence 11. Dès lors, la position du circuit intégré radiofréquence 11 est déterminée et figée relativement à celle du palet 12.

On obtient ainsi, comme illustré sur les figures 17A et 17B, sur le premier substrat porteur 31, une première partie du module frontal. De la même manière que précédemment, en fonction d'une éventuelle profondeur de meulage de la surface exposée de la première partie du module frontal, soit une épaisseur H du premier matériau diélectrique 16 subsiste au-dessus du circuit intégré radiofréquence 11 (Cf. Figure 17A), soit la face arrière 114 du circuit intégré radiofréquence 11 se trouve exposée (Cf. Figure 17B).

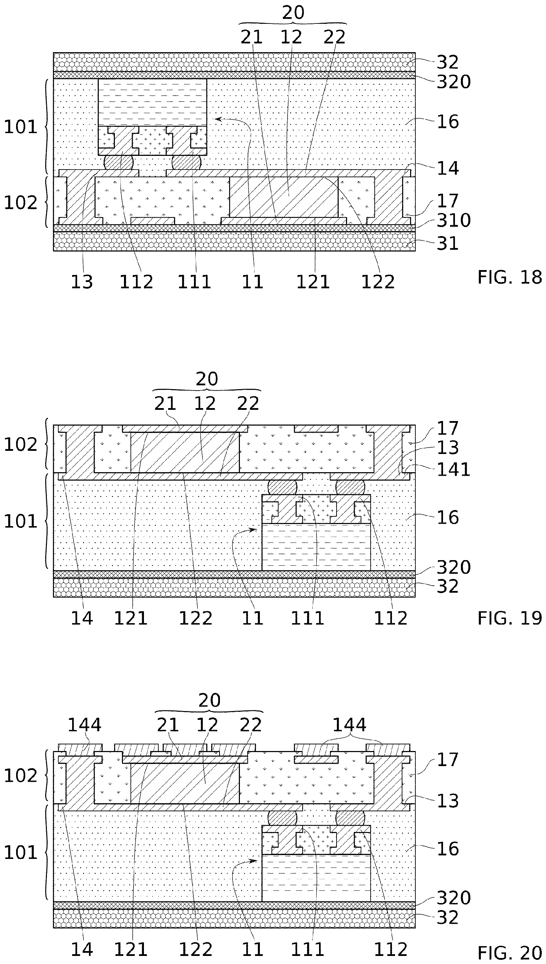

Quelle que soit l'alternative choisie, un transfert, tel qu'illustré sur les figures 18 et 19, de la première partie du module frontal depuis le premier substrat porteur 31 sur le second substrat porteur 32 par la face exposée de la première partie du module frontal est ensuite réalisé de sorte que la première partie du module frontal puisse être traitée depuis son autre face, pour finir de former le module frontal 1.

Comme illustré sur la figure 20, et de la même façon que décrite ci-dessus (en référence à la figure 8), une formation de pads d'entrée/sortie 144 du module frontal 1 est réalisée sur le premier niveau métallique de connexion électrique 141.

Dès lors, il suffit d'ajouter, comme illustré sur la figure 21, éventuellement des boules d'étain ou des piliers en cuivre sur chacun des pads d'entrée/sortie 144, et de retirer, par exemple par décollage, le second substrat porteur 32, pour obtenir le module frontal 1 tel qu'illustré sur la figure 22.

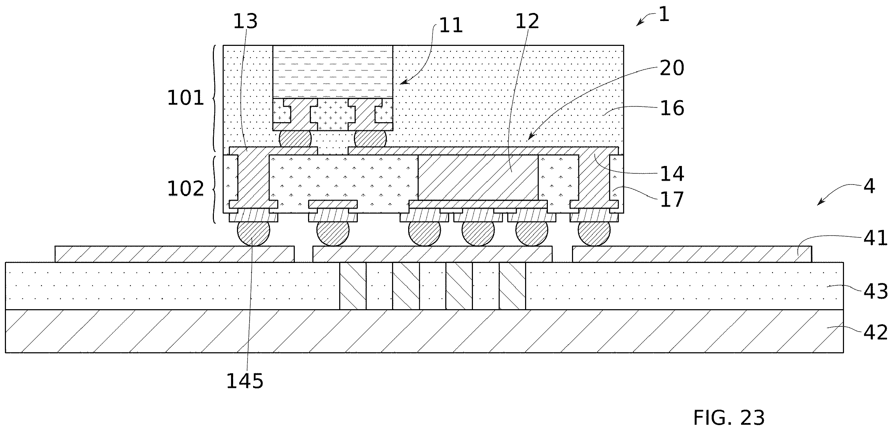

De la même façon que discuté plus haut en référence à la figure 11, le module frontal 1 est alors fabriqué et prêt à être assemblé aux autres composants d'un système radiofréquence ou sur une carte d'évaluation 4 du module 1, par exemple de la façon illustrée sur la figure 23.

Pour distinguer les deux modes de mise en oeuvre du procédé qui sont décrits ci-dessus, l'un en référence aux figures 1 à 11 et l'autre en référence aux figures 12 à 21, et bien que ces deux modes relèvent d'une même approche, notons que le premier des deux modes consiste à reporter d'abord le circuit intégré radiofréquence 11 par sa face avant 113 sur un premier substrat porteur 31, tandis que le second des deux modes consiste d'abord à concevoir des parties du package destiné à maintenir en position relative, et de façon fonctionnelle (de par leurs connexions électriques), le circuit intégré radiofréquence 11 et le composant magnétique 20. Ainsi, le premier mode de mise en oeuvre du procédé selon l'invention décrit ci-dessus peut être qualifié de mode « die first / face down », et le deuxième mode de mise en oeuvre du procédé selon l'invention décrit ci-dessus peut être qualifié de mode « RDL first ».

Il est à noter que des modules frontaux 1 selon l'invention fabriqués selon les deux modes du procédé selon l'invention décrits ci-dessus présente une capacité de dissipation thermique satisfaisante ce qui rend cette solution adaptée à des applications de haute puissance. Néanmoins, à mesure que le palet 12 est plus épais, comme l'épaisseur du package augmente proportionnellement, les chemins de dissipation thermique peuvent venir à se dégrader. De plus, l'épaisseur totale du package est élevée et essentiellement déterminée par la somme de l'épaisseur du circuit intégré radiofréquence 11 et du palet 12, cette épaisseur étant encore augmentée si la liaison du module frontal 1 à d'autres éléments d'un système radiofréquence ou à une carte d'évaluation 4 peut faire intervenir des connexions par fils électriques (ou « wire bonding » selon la terminologie anglo-saxonne). Ainsi, dans le cas où l'application nécessiterait de pouvoir bien dissiper la chaleur émise, on préférera les autres exemples de réalisation dans lesquels le circuit intégré et le palet sont dans une même couche diélectrique.

Comme mentionné plus haut, une seconde approche est également proposée qui permet d'aboutir à ce que le circuit intégré radiofréquence 11 et le composant magnétique 20 se situent tous deux dans un même niveau 101 du module frontal 1. Cette seconde approche se décline en deux modes de mise en oeuvre du procédé de fabrication selon l'invention dont un mode nommé troisième mode de mise en oeuvre est décrit ci-dessous en référence aux figures 24 à 31 et l'autre mode nommé quatrième mode de mise en oeuvre est décrit ci-dessous en référence aux figures 33 à 41.

Comme illustré sur la figure 24, le troisième mode de mise en oeuvre du procédé de fabrication selon l'invention comprend tout d'abord un report du circuit intégré radiofréquence 11 et du palet 12 sur le premier substrat porteur 31. Plus particulièrement, le circuit intégré radiofréquence 11 est reporté sur le premier substrat porteur par sa face avant 113 et le palet 12 est reporté sur le premier substrat porteur par une de ses première et deuxième surfaces principales 121, 122.

Notons ici que, sur l'exemple illustré sur la figure 24, le circuit intégré 11 présente une structure telle qu'illustrée sur la figure 48B qui a déjà été décrite plus haut.

S'ensuit, comme illustré sur la figure 25, un dépôt du premier matériau diélectrique 16 sur le premier substrat porteur 31 au moins autour du circuit intégré radiofréquence 11 et du palet 12. Dès lors, le circuit intégré radiofréquence 11 et le palet 12 sont maintenus en position relative l'un par rapport à l'autre. Dans le cas d'un surmoulage, une étape de meulage peut être prévue de sorte à ramener l'épaisseur du premier matériau diélectrique 16 à une valeur H1 au-dessus du circuit intégré radiofréquence 11 et à une valeur H2 au-dessus du palet 12, suivant les épaisseurs relatives du circuit intégré radiofréquence 11 et du palet 12 entre elles. En alternative, l'une ou l'autre des valeurs H1 et H2 peut être portée à zéro, exposant ainsi l'une ou l'autre parmi la face arrière 114 du circuit intégré radiofréquence 11 et la surface principale 121 du palet 12 opposée à celle par laquelle le palet 12 a été reporté sur le premier substrat porteur 31.

L'on comprend ainsi que, selon le cas de figure, un meulage du premier matériau diélectrique 16 puisse être prévue pour exposer la face arrière 114 du circuit intégré radiofréquence 11 et/ou la surface principale du palet 12 opposée à celle par laquelle le palet 12 a été reporté sur le premier substrat porteur 31.

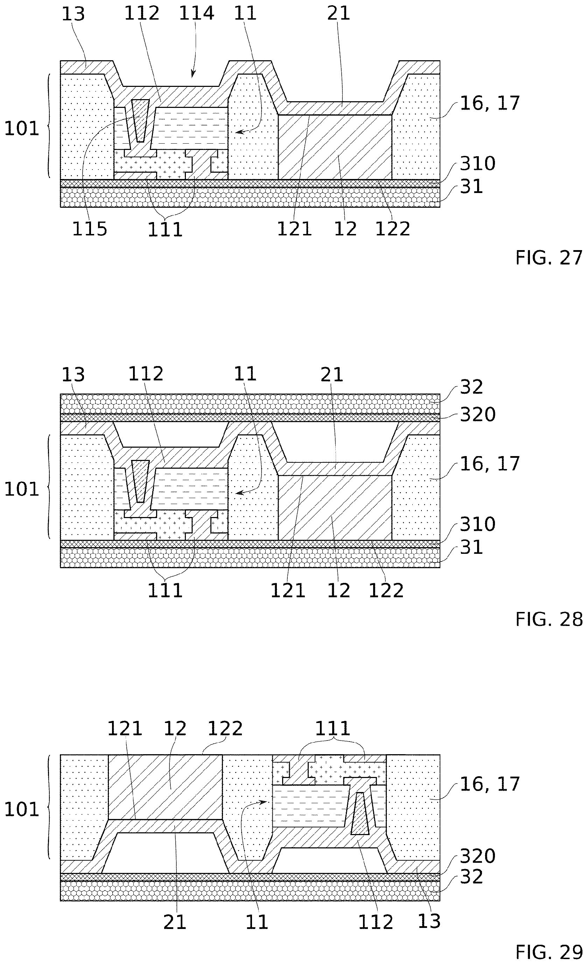

Une fois exposées, la face arrière 114 du circuit intégré radiofréquence 11 et/ou la surface principale du palet 12 opposée à celle par laquelle le palet 12 a été reporté sur le premier substrat porteur 31, un dépôt de la première piste métallique de connexion électrique 13, est réalisé, pour obtenir, sur le premier substrat porteur 31, une première partie du module frontal, de la façon illustrée sur la figure 27. On notera que la piste métallique de connexion électrique 13 relie entre elles la première surface principale 121 du palet 12 et la face arrière 114 du circuit intégré radiofréquence 11, cette face arrière 114 servant ainsi de connexion à la masse du circuit intégré radiofréquence 11, qui rappelons-le comprend un via 115 à cette fin.

Un transfert de la première partie du module frontal depuis le premier substrat porteur 31 sur le second substrat porteur 32 par la face de la première partie du module frontal sur laquelle est exposée la première piste métallique de connexion électrique 13 est ensuite réalisé comme illustré sur les figures 28 et 29.

De la sorte, la première partie du module frontal peut être traitée depuis sa surface exposée après son transfert, pour finir de former le module frontal 1.

Selon le troisième mode de mise du procédé de fabrication considéré ici, la finalisation du module frontal 1 tel qu'illustré sur la figure 31, comprend la formation de la deuxième piste métallique de connexion électrique 14 sur la surface exposée de la première partie du module frontal après son transfert. En référence à la figure 30, la deuxième piste métallique de connexion électrique 14 est formée dans une couche de redistribution RDL comprenant, dans cet exemple, deux niveaux métalliques de connexion électrique 141 et 142 interconnectés entre eux par l'intermédiaire de vias métalliques 143 à travers un troisième matériau diélectrique 18.

Après retrait du deuxième substrat porteur 32, on obtient le module frontal 1 tel qu'illustré sur la figure 31.

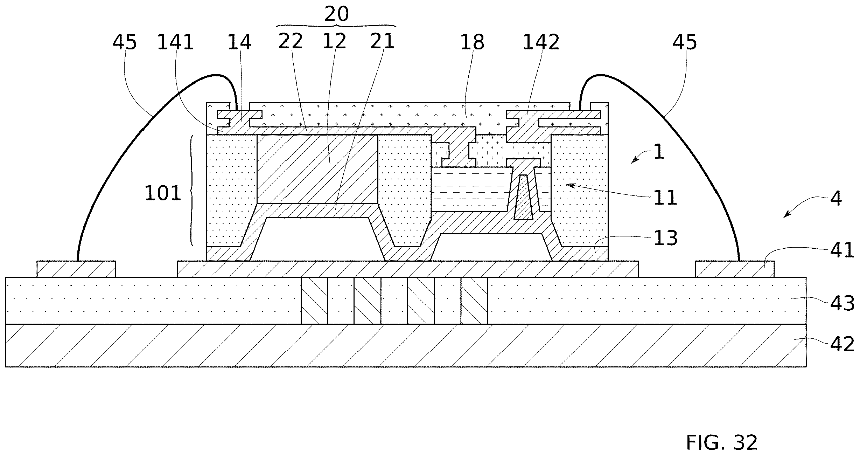

De la même façon que discuté plus haut en référence aux figures 11 et 23, le module frontal 1 est alors fabriqué et prêt à être assemblé aux autres composants d'un système radiofréquence ou sur une carte d'évaluation 4 du module 1, par exemple de la façon illustrée sur la figure 32. Notons ici que, contrairement aux assemblages illustrés sur les figures 11 et 23, l'assemblage tel qu'illustré sur la figure 32 fait intervenir deux connexions par fils de liaison électrique 45 (ou « wire bonding » selon la terminologie anglo-saxonne). Plus particulièrement, la connexion des entrées/sortie du module frontal 1 sur la carte d'évaluation 3 est réalisée par les fils de liaison électrique 45.

Le quatrième mode de mise en oeuvre du procédé de fabrication selon l'invention est décrit ci-dessous en référence aux figures 33 à 41.

En référence à la figure 33, le quatrième mode de mise en oeuvre comprend tout d'abord la formation d'une couche de redistribution RDL comprenant dans cet exemple deux niveaux métalliques de connexion électrique 141 et 142 interconnectés entre eux par l'intermédiaire de vias métalliques 143 à travers un troisième matériau diélectrique 18. Ce réseau RDL comprend l'une des deux pistes métalliques de connexion électrique, à savoir la piste « signal » 14.

S'ensuit, comme illustré sur la figure 34, le report du circuit intégré radiofréquence 11 et du palet 12 sur le premier substrat porteur 31. Plus particulièrement, le circuit intégré radiofréquence 11 est reporté sur le premier substrat porteur 31 par sa face avant 113 et le palet 12 est reporté sur le premier substrat porteur par une de ses première et deuxième surfaces principales 121, 122.

Notons ici que, comme sur l'exemple illustré sur la figure 24, le circuit intégré 11 présente, sur la figure 34, une structure telle qu'illustrée sur la figure 48B qui a déjà été décrite plus haut.

Toujours en référence à la figure 34, on forme ensuite sur une piste métallique de la couche de redistribution RDL un pilier métallique de connexion électrique 19. Le pilier 19 présente une hauteur supérieure à la plus grande parmi une épaisseur du circuit intégré radiofréquence 11 entre sa face avant 113 et sa face arrière 114 et une épaisseur du palet 12 entre ses surfaces principales 121 et 122. La hauteur de chaque pilier 19 peut par exemple être comprise selon les cas entre 50 et 200 microns.

Comme illustré sur la figure 35, s'ensuit un dépôt du premier matériau diélectrique 16 sur le premier substrat porteur 31 au moins autour du circuit intégré radiofréquence 11 et du palet 12, et autour du pilier 19, et, le cas échéant, jusqu'à recouvrir l'ensemble.

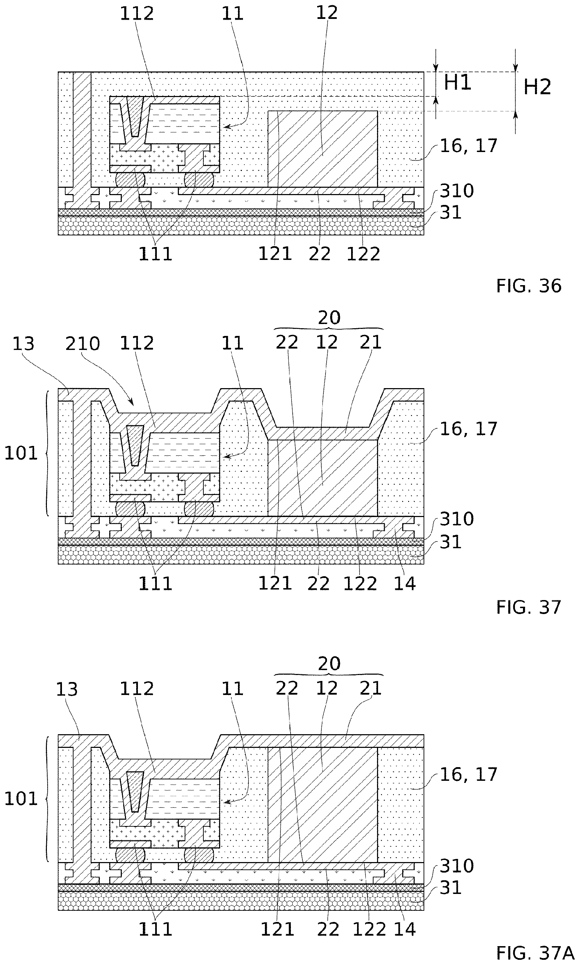

Toujours dans la maîtrise des épaisseurs H1 et H2 déjà discutées plus haut et telles qu'illustrées sur la figure 36, une étape de meulage peut être réalisée qui peut viser le cas échéant à exposer le sommet du pilier 19.

L'on comprend que, selon le cas de figure, un meulage du premier matériau diélectrique 16 puisse être prévue pour exposer la face arrière 114 du circuit intégré radiofréquence 11 et/ou la surface principale du palet 12 opposée à celle par laquelle le palet 12 a été reporté sur le premier substrat porteur 31. Par exemple, sur la figure 37A, est illustré un cas dans lequel le palet 12 présente une épaisseur supérieure à celle du circuit intégré radiofréquence 11 et dans lequel l'étape de meulage susmentionnée a conduit à exposer la surface principale 121 du palet 12, le cas échéant en plus du sommet du pilier 19. Le quatrième mode de mise en oeuvre présentement décrit montre donc son potentiel à considérer toutes formes et dimensions du palet 12, notamment relativement à celle(s) du circuit intégré radiofréquence 11.

Une fois exposées la face arrière 114 du circuit intégré radiofréquence 11 et la surface principale 121 du palet 12, un dépôt d'une partie au moins de la piste métallique de connexion électrique 13 est réalisé, pour obtenir, sur le premier substrat porteur 31, une première partie du module frontal, de la façon illustrée sur l'une ou l'autre des figures 37 et 37A.

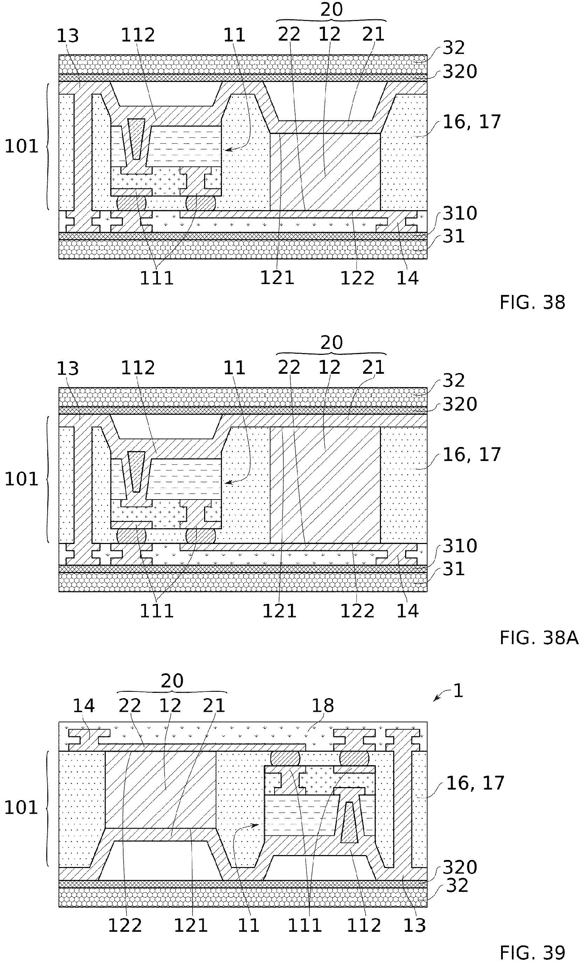

La figure 38 reprend le cas illustré sur la figure 37, sans préjudice d'une possibilité d'adaptation des étapes décrites ci-dessous au cas illustré sur la figure 37A. De telles étapes adaptées sont d'ailleurs illustrées sur les figures 38A et 40A.

Sur les figures 38 et 39, est illustré le transfert de la première partie du module frontal depuis le premier substrat porteur 31 sur le second substrat porteur 32. Il est dès lors possible de finaliser, comme représenté sur les figures 39 et 40, le module frontal 1 en formant des zones de reprise de contact d'entrée/sortie du module frontal 1 sur le niveau métallique de connexion électrique 142. Cette étape peut être réalisée en ouvrant par endroits, par exemple par gravure, une couche supérieure du troisième matériau diélectrique 18. Des pads d'entrée/sortie peuvent le cas échéant venir habiller lesdites zones de reprise de contact.

Notons que le transfert tel qu'illustré sur les figures 38A et 40A n'induit pas particulièrement la nécessité d'adapter les étapes de finalisation du module frontal 1 tel que décrite ci-dessus en référence aux figures 39 et 40.

Après retrait du deuxième substrat porteur 32, on obtient le module frontal 1 tel qu'illustré sur la figure 41.

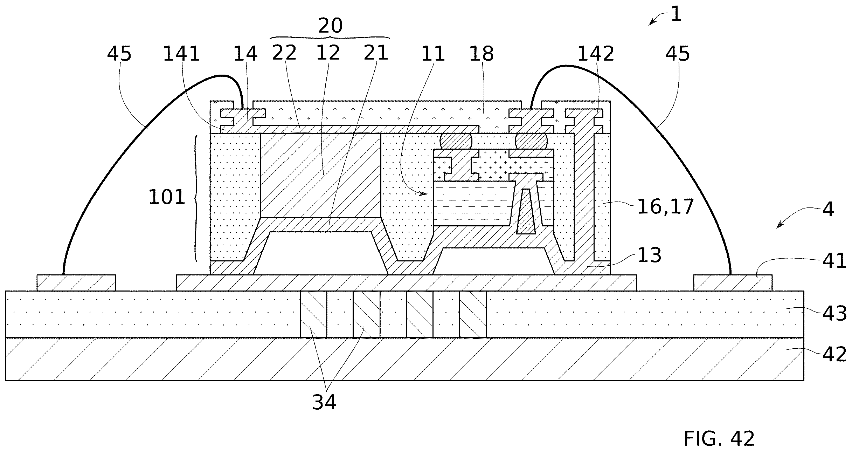

De la même façon que discuté plus haut, le module frontal 1 est alors fabriqué et prêt à être assemblé aux autres composants d'un système radiofréquence ou sur une carte d'évaluation 4 du module 1, par exemple de la façon illustrée sur la figure 42. Notons que l'assemblage tel qu'illustré sur la figure 42 fait intervenir deux connexions par fils de liaison électrique 45 (ou « wire bonding » selon la terminologie anglo-saxonne).

On s'aperçoit que, dans des modules frontaux 1 selon l'invention obtenus par les troisième et quatrième modes de mise en oeuvre du procédé selon l'invention, les différents niveaux de connexion électrique 141 et 142 ne sont plus séparés entre eux par le palet 12, de sorte que la distance qui sépare ces niveaux de métallisation n'est plus déterminée par l'épaisseur du palet 12 ; ceci confère, aux modules frontaux 1 obtenus par mise en oeuvre de la seconde approche décrite ci-dessus, une dissipation de chaleur optimale quelle que soit la configuration, et notamment quelle que soit l'épaisseur du palet.

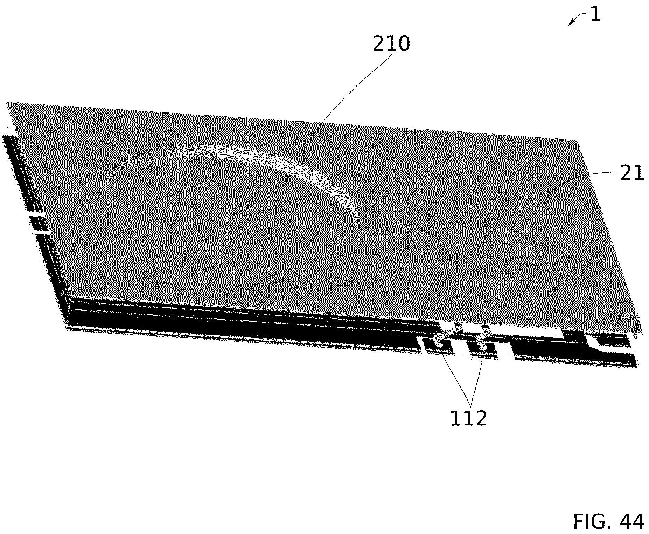

Notons néanmoins que, lorsque le palet 12 présente une épaisseur inférieure à celle du circuit intégré radiofréquence 11 (celle-ci étant typiquement inférieure à 100 microns, y compris l'épaisseur des perles de soudure), les troisième et quatrième modes de mise en oeuvre du procédé selon l'invention peuvent nécessiter d'ouvrir le matériau diélectrique 16, 17 au-dessus du palet 12 (après avoir placé le palet et recouvert le palet et le reste de diélectrique), pour créer une cavité (ou évidement) 210 (Cf. par exemple figure 44) en son sein et pouvoir y reprendre le contact à la masse. De façon similaire, si un pilier 19 présente une hauteur supérieure à l'épaisseur du circuit intégré 11 et du palet 12, il peut être nécessaire de creuser une cavité au-dessus de chacun de ces éléments. On notera que les premier et deuxième modes de mise en oeuvre du procédé selon l'invention ne présentent pas cette limite.

Notons que chacun des quatre modes de mise en oeuvre décrits ci-dessus du procédé de fabrication selon l'invention comprend les étapes suivantes :
- Fournir un circuit intégré radiofréquence 11, un palet 12 à base d'un matériau magnétique auto-polarisé, un premier substrat porteur 31 et un second substrat porteur 32, le circuit intégré radiofréquence 11 comprenant plusieurs zones de connexion électrique 111, 112 dont une première zone 111 destinée à recevoir et/ou émettre un signal électrique et une deuxième zone 112 destinée à être reliée à la masse, et le palet 12 comprenant une première surface principale 121 et une deuxième surface principale 122 opposée à la première, puis
- Assembler le circuit intégré radiofréquence 11 et le palet 12en se servant du premier substrat porteur 31 comme support pour des premières étapes de fabrication du module frontal, puis comme substrat de transfert sur le second substrat support 32 pour des deuxièmes étapes de fabrication du module frontal ; en utilisant au moins l'un parmi un premier matériau diélectrique 16 et un deuxième matériau diélectrique 17 pour maintenir mécaniquement au moins le circuit intégré radiofréquence 11 et le palet 12 en position relative l'un par rapport à l'autre grâce à un « enrobage » du circuit intégré 11 et du palet 12 par un matériau diélectrique 16, 17 réalisé par un procédé de conditionnement de type FOWLP ; en formant une couche de redistribution RDL de connexions électriques placée au-dessus de la couche d'enrobage comprenant ledit premier matériau diélectrique et comprenant une piste métallique de connexion électrique reliant la deuxième surface principale 122 du palet 12 et ladite première zone de connexion électrique 112 du circuit intégré 11 pour permettre la transmission d'un signal électrique entre le palet et le circuit intégré.

Par ailleurs, il en va de même d'un cinquième mode de mise en oeuvre du procédé de fabrication selon l'invention qui comprend :
- le dépôt par exemple par placage d'une couche épaisse de cuivre sur un premier substrat porteur, puis le patterning de cette couche (ou la « création/formation de motifs dans cette couche ») pour créer des piliers métalliques,
- le report du circuit intégré radiofréquence 11 et du palet 12 entre les piliers en cuivre,
- le dépôt du premier matériau diélectrique 16, en surmoulage, sur le premier substrat porteur, puis un éventuel meulage,
- le cas échéant (si le palet 12 est d'une épaisseur inférieure à celle du circuit intégré radiofréquence 11), la formation d'une cavité 210 dans le premier matériau diélectrique 16 de sorte à exposer une des surfaces principales du palet 12,
- le dépôt d'un plan de masse, puis son éventuel patterning,
- le transfert sur un second substrat porteur,
- le dépôt d'un premier niveau de métallisation, puis son patterning,
- le dépôt d'un matériau diélectrique 18, avant celui d'un deuxième niveau de métallisation, puis son éventuel patterning, et
- la formation de pads de connexion.

Ce cinquième mode de mise en oeuvre tel que décrit ci-dessus bien qu'il ne soit pas illustré sur les figures annexées, et donc malgré tout couvert par la portée des revendications annexées. Sa variante ci-dessus décrite s'inscrit dans le cadre de l'approche « RDL first » décrite ci-dessus, mais le cinquième mode de mise en oeuvre peut tout aussi bien être décliné selon une autre variante adaptée à l'approche « Die first » décrite ci-dessus.

Notons encore que chacun des quatre premiers modes de mise en oeuvre décrits ci-dessus du procédé de fabrication selon l'invention est tel que :
- l'un parmi le circuit intégré radiofréquence 11 et le palet 12 est d'abord reporté sur l'un ou l'autre parmi le premier substrat support 31 et le deuxième substrat support 32 avant que l'un ou l'autre parmi le premier matériau diélectrique 16 et le deuxième matériau diélectrique 17 ne soit utilisé pour le maintenir mécaniquement dans la position de son report et l'autre parmi le circuit intégré radiofréquence 11 et le palet 12 est d'abord reporté sur l'un ou l'autre parmi le premier substrat support 31 et le deuxième substrat support 32 avant que l'un ou l'autre parmi le premier matériau diélectrique 16 et le deuxième matériau diélectrique 17 ne soit utilisé pour le maintenir mécaniquement dans la position de son report, y compris le cinquième mode de mise en oeuvre introduit ci-dessus, et/ou
- au moins l'une parmi la première piste métallique de connexion électrique 13 et la deuxième piste métallique de connexion électrique 14 est formée avant le report du palet 12, à l'exclusion du cinquième mode de mise en oeuvre introduit ci-dessus.

Notons que, si au moins un des palets 12 est épais, il est effectivement plutôt intéressant de mettre en oeuvre le procédé selon l'invention conforme à la seconde approche aboutissant à la disposition du circuit intégré 11 et du palet 12 dans un même niveau du module frontal 1. Si à l'inverse le palet 12 est mince, plus mince que le circuit intégré 11, un choix entre première et seconde approches peut être à arbitrer. En effet, la seconde approche implique une étape de procédé supplémentaire pour faire la première piste métallique de connexion électrique 13 reliée à la masse en face arrière 114 du circuit intégré 11 et nécessite des circuits intégrés 11 avec TSV 115. Si le palet 12 est mince, la première approche peut donc être préférable, car la surépaisseur de la couche de redistribution RDL est faible et on a une étape de moins. En outre, quand le circuit intégré 11 et le palet 12 sont sur des couches différentes, on peut en pratique les mettre plus proches, voire les chevaucher, voire même les superposer si le rayonnement magnétique est compatible avec un bon fonctionnement du circuit intégré 11 et gagner en surface.

Il a déjà été fait référence ci-dessus aux figures 43 et 45 qui sont plus complètes et plus détaillées que les figures en référence auxquelles les différents modes de mise en oeuvre du procédé de fabrication selon l'invention ont été décrits ci-dessus. Notons que la figure 44 fait apparaître, sur la face arrière du module frontal 1, une cavité 210 illustrant la variation de niveau de la piste métallique de connexion électrique 13 qui est désignée par la même référence sur la figure 41.

Il apparaît en outre, sur les figures 43 à 45, que la technologie de packaging utilisée permet d'intégrer un à plusieurs niveaux métalliques noyés dans un matériau diélectrique, par exemple de type oxyde, de sorte à :
- réaliser les pads d'entrée/sortie et de masse du module frontal 1,
- dessiner le plan de masse ainsi que le niveau signal du composant magnétique 20,
- faire la jonction électrique entre le ou les circuits intégrés radiofréquence 11, 11' et le composant magnétique,
- faire la jonction entre les entrées/sortie du ou des circuits intégrés radiofréquence 11, 11' et des entrées/sortie du module frontal 1, et
- réaliser des fonctions passives telles que des inductances, des transformateurs, des baluns, etc.

En comparant les figures 45 et 46 entre elles, il apparaît que la figure 46 peut être vue comme un schéma électrique simplifié du schéma de la figure 45. Les figures 46A à 46I illustrent d'autres exemples, que celui donné à la figure 46, de tels schémas électriques de modules frontaux pouvant être obtenus selon l'un quelconque des modes de mise en oeuvre du procédé de fabrication décrits ci-dessus. Autrement dit, les figures 46A à 461 illustrent des schémas électriques de modules frontaux selon l'invention, bien que ces schémas simplifiés puissent être connus par ailleurs. Il ressort de ses différents exemples donnés que la présente invention peut être vue comme une nouvelle technologie d'intégration pour la fabrication de modules frontaux radiofréquence (ou FEM pour « Front End Module » selon la terminologie anglo-saxonne), d'amplificateur de puissance 5 (ou PA pour « Power Amplifier » selon la terminologie anglo-saxonne) et des modules d'émission et de transmission TRX radiofréquence qui intègre au moins un composant magnétique 20, tel qu'un circulateur. Cette nouvelle technologie d'intégration peut être qualifiée de technologie d'intégration de type FOWLP (pour « Fan-out wafer-level packaging » selon la terminologie anglo-saxonne) à faible coût. Elle est en outre compatible avec l'intégration de plusieurs circuits intégrés et avec un assemblage impliquant diverses technologies.

La présente invention répond ainsi à un besoin stratégique en matière de modules d'émission et de réception utilisée dans les radars et les plates-formes de communication et qui notamment porte sur la miniaturisation des électroniques à base de semi-conducteurs ainsi qu'à leur intégration avec des éléments de commande magnétique, comprenant notamment de la ferrite, tels qu'un circulateur et/ou un isolateur. Un circulateur est en effet l'un des plus importants éléments pour permettre l'émission et la réception simultanées dans une même bande de fréquence (Full-duplex). De plus, l'amplificateur de puissance PA 5 à faible bruit (ou LNA pour « Low Noise Amplifier » selon la terminologie anglo-saxonne), par exemple tel qu'illustré sur les figures 46A à 46H, peut, par mise en oeuvre de la nouvelle technologie d'intégration proposée, être protégé contre les désadaptations de charge d'antenne, ce qui contribue à assurer un fonctionnement optimal des systèmes radiofréquence intégrant des modules frontaux 1 selon l'invention.

Du fait de son haut niveau d'intégration, la nouvelle technologie d'intégration proposée permet de réduire les interconnexions, et en particulier leur longueur, entre le circuit intégré radiofréquence 11 et le composant magnétiques 20. La taille du module frontal 1, les pertes, notamment de charge, et la consommation énergétique sont ainsi avantageusement réduites. En proposant l'intégration du matériau magnétique sous la forme d'un palet 12 solide de ce matériau dans une technologie d'intégration de type FOWLP, la présente approche se distingue des approches qui selon l'art antérieur prévoient l'intégration du matériau magnétique selon des processus micro-électroniques standards. Grâce à l'approche proposée, le positionnement du matériau magnétique est bien contrôlé et ne nécessite pas de colle, tel qu'une époxy ou un adhésif, pour stabiliser mécaniquement le composant magnétiques 20 et ses jonctions. Par ailleurs, la nouvelle technologie d'intégration proposée permet d'éviter le gaspillage de larges zones de substrats semi-conducteurs, ce qui est d'autant plus intéressant que ceux-ci sont parfois très coûteux, spécialement lorsqu'il s'agit de substrats de composition III-V.

Pour aller plus loin, la nouvelle technologie d'intégration proposée rend possible l'intégration d'antenne sur un module frontal 1 selon l'invention, notamment via ses pads 144, et/ou au besoin en utilisant l'option technologique connue sous le sigle TMV. Cette technologie peut encore être utilisée pour réaliser un blindage au champ électrique ou pour créer aussi bien des circulateurs d'architecture plus avancée que celles illustrées sur les figures 47A et 47B, par exemple une topologie de circulateur connu sous le sigle SIW (pour « Substrate Integrated Waveguide » selon la terminologie anglo-saxonne), qu'un dissipateur de chaleur.

En outre, et comme déjà mentionné ci-dessus, les deux approches décrites ci-dessus permettent l'intégration de palet 12 à base d'un matériau magnétique de différentes formes et dimensions.

Chaque étape susmentionnée qui consiste en un report d'un élément sur un autre peut être avantageusement réalisée par une machine de type « pick-and-place ».

Les différentes pistes conductrices, ainsi que les différents niveaux conducteurs, peuvent faire intervenir la technologie TMV, une technologie de placage et/ou du patterning.

L'invention n'est pas limitée aux modes de réalisations et mise en oeuvre précédemment décrits et s'étend à tous les modes de réalisation et de mise en oeuvre couverts par les revendications.

Par exemple, les surfaces principales du palet ne prennent pas nécessairement la forme d'un disque, mais peuvent prendre celle d'un carré, d'un triangle, d'un pentagone, etc.

Par exemple, si la seconde approche décrite ci-dessus à travers les troisième et quatrième modes de mise en oeuvre du procédé sont particulièrement adaptés à des circuits intégrés 11 avec TSV 115, ils ne sont pour autant pas limités à de tels circuits intégrés 11, mais ont au contraire adaptables à d'autres architectures de circuits intégrés, telles que par exemple celle illustrée par la figure 48A. Cette adaptation peut notamment passer par l'utilisation d'un pilier de remontée de masse traversant le matériau diélectrique 16 jusqu'à la couche de redistribution RDL pour « récupérer » la masse.

## Revendications

1. Module frontal (1) d'émission et/ou réception radiofréquence comprenant :
• un circuit intégré radiofréquence (11) comprenant au moins deux zones de connexion électrique (111, 112) dont une première zone (111) destinée à recevoir ou émettre un signal et une deuxième zone (112) destinée à être reliée à la masse,
• un palet (12) à base d'un matériau magnétique auto-polarisé comprenant une première surface principale (121) et une deuxième surface principale (122) opposée à la première,
**Caractérisé en ce qu'**il comprend :
• un premier matériau diélectrique (16) et un deuxième matériau diélectrique (17) formant une couche d'enrobage latéral respective du circuit intégré radiofréquence (11) et du palet (12) en les maintenant mécaniquement en position l'un par rapport à l'autre, et
• une couche de redistribution RDL de connexions électriques placée au-dessus de la couche d'enrobage comprenant ledit premier matériau diélectrique (16), la couche de redistribution RDL comprenant une piste métallique de connexion électrique de signal (14) reliant la deuxième surface principale (122) du palet (12) et ladite première zone de connexion électrique (111) du circuit intégré pour permettre la transmission d'un signal électrique entre le palet (12) et le circuit intégré (11).

2. Module frontal (1) selon la revendication 1, dans lequel la première surface principale (121) du palet est reliée électriquement à un premier plot de connexion externe du module destiné à être relié à la masse, et dans lequel la deuxième zone de connexion électrique (112) du circuit intégré radiofréquence (11) est reliée électriquement au premier plot ou à un deuxième plot de connexion externe du module et destiné à être relié à la masse également.

3. Module frontal (1) selon la revendication 1, dans lequel le composant magnétique (20) constitue ou comprend au moins l'un parmi un circulateur, un gyrateur et un isolateur.

4. Module frontal (1) selon l'une quelconque des revendications précédentes, dans lequel le premier matériau diélectrique (16) et le deuxième matériau diélectrique (17) s'étendent sur un même niveau (101) du module frontal (1) en formant une unique couche dans laquelle le circuit intégré radiofréquence (11) et le palet (12) sont placés.

5. Module frontal (1) selon l'une quelconque des revendications 1 à 3, dans lequel le premier matériau diélectrique (16) forme une première couche dans laquelle le circuit intégré radiofréquence (11) est intégré et le deuxième matériau diélectrique (17) forme une deuxième couche dans laquelle le palet (12) est intégré, la deuxième couche du deuxième matériau diélectrique correspondant en tout ou partie à des couches diélectriques constitutives de la couche de distribution RDL de connexions électriques.

6. Module frontal (1) selon l'une quelconque des revendications précédentes, dans lequel une épaisseur du palet (12) entre ses surfaces principales (121, 122) est supérieure à une épaisseur du circuit intégré radiofréquence (11) entre sa face avant (113) et sa face arrière (114).

7. Module frontal (1) selon l'une quelconque des revendications précédentes, dans lequel la piste métallique de connexion électrique de signal (14) a une géométrie tridimensionnelle et/ou est formée sur au moins deux niveaux métalliques de connexion électrique (141, 142) interconnectés entre eux par l'intermédiaire de vias métalliques.

8. Module frontal (1) selon l'une quelconque des revendications précédentes, dans lequel le circuit intégré radiofréquence (11) présente au moins un via (115) s'étendant depuis la face arrière du circuit intégré radiofréquence à travers un substrat semiconducteur dans lequel sont formés des composants actifs du circuit intégré radiofréquence, et dans lequel la face arrière (114) du circuit intégré radiofréquence constitue une zone de connexion à la masse (112) du circuit intégré radiofréquence (11).

9. Procédé de fabrication d'un module frontal (1) d'émission et/ou réception radiofréquence comprenant :
• Fournir un circuit intégré radiofréquence (11), un palet (12) à base d'un matériau magnétique auto-polarisé, un premier substrat porteur (31) et un second substrat porteur (32), le circuit intégré radiofréquence (11) comprenant plusieurs zones de connexion électrique (111, 112) dont une première zone (111) destinée à recevoir et/ou émettre un signal électrique et une deuxième zone (112) destinée à être reliée à la masse, et le palet (12) comprenant une première surface principale (121) et une deuxième surface principale (122) opposée à la première, puis
• Assembler le circuit intégré radiofréquence (11) et le palet (12) en se servant du premier substrat porteur (31) comme support pour des premières étapes de fabrication du module frontal, puis comme substrat de transfert sur le second substrat support (32) pour des deuxièmes étapes de fabrication du module frontal ; en utilisant au moins l'un parmi un premier matériau diélectrique (16) et un deuxième matériau diélectrique (17) pour former, par un procédé de conditionnement de type FOWLP, une couche d'enrobage latéral respective dudit circuit intégré radiofréquence (11) et du palet (12) et les maintenir mécaniquement en position l'un par rapport à l'autre ; en formant une couche de redistribution RDL de connexions électriques placée au-dessus de la couche d'enrobage comprenant ledit premier matériau diélectrique et comprenant une piste métallique de connexion électrique de signal (14) reliant la deuxième surface principale (122) du palet (12) et ladite première zone de connexion électrique (111) du circuit intégré pour permettre la transmission d'un signal électrique entre le palet et le circuit intégré.

10. Procédé de fabrication selon la revendication précédente, comprenant la formation d'une liaison électrique entre la première surface principale (121) du palet et un premier plot de connexion externe du module destiné à être relié à la masse, et comprenant la formation d'une liaison électrique entre une deuxième zone de connexion électrique (112) du circuit intégré radiofréquence (11) et un premier plot ou un deuxième plot de connexion externe du module et destiné à être relié à la masse également.

11. Procédé de fabrication selon la revendication précédente, comprenant la formation d'une liaison électrique entre la première surface principale (121) du palet et la deuxième zone de connexion électrique (112) du circuit intégré radiofréquence (11) par une piste métallique de connexion à la masse (13) formée au contact de la couche d'enrobage comprenant le premier matériau diélectrique, du côté opposé à la couche de redistribution RDL.

12. Procédé de fabrication selon l'une des revendications 9 à 11, dans lequel l'un parmi le circuit intégré radiofréquence (11) et le palet (12) est d'abord reporté sur l'un ou l'autre parmi le premier substrat support (31) et le deuxième substrat support (32) avant que l'un ou l'autre parmi le premier matériau diélectrique (16) et le deuxième matériau diélectrique (17) ne soit utilisé pour le maintenir mécaniquement dans la position de son report et l'autre parmi le circuit intégré radiofréquence (11) et le palet (12) est d'abord reporté sur l'un ou l'autre parmi le premier substrat support (31) et le deuxième substrat support (32) avant que l'un ou l'autre parmi le premier matériau diélectrique (16) et le deuxième matériau diélectrique (17) ne soit utilisé pour le maintenir mécaniquement dans la position de son report.

13. Procédé de fabrication selon l'une des revendications 9 à 12, comprenant :
• un report du circuit intégré radiofréquence (11) et du palet (12) sur le premier substrat porteur (31), le circuit intégré radiofréquence étant reporté sur le premier substrat porteur par sa face avant (113) et le palet étant reporté sur le premier substrat porteur par une de ses première et deuxième surfaces principales (121, 122),
• un dépôt du premier matériau diélectrique (16) sur le premier substrat porteur (31) au moins autour du circuit intégré radiofréquence (11) et du palet (12),
• un dépôt d'une piste métallique de connexion à la masse (13),
pour obtenir sur le premier substrat porteur (31) une première partie du module frontal, puis
• un transfert de la première partie du module frontal depuis le premier substrat porteur (31) sur le second substrat porteur (32) par la face de la première partie du module frontal sur laquelle est exposée la piste métallique de connexion à la masse (13),
de sorte que la première partie du module frontal puisse être traitée depuis sa surface exposée après son transfert, pour finir de former le module frontal (1).

14. Procédé selon l'une quelconque des revendications 9 à 12, comprenant :
• un report du circuit intégré radiofréquence (11) sur le premier substrat porteur (31) par sa face avant (113),
• un dépôt du premier matériau diélectrique (16) sur le premier substrat porteur (31) au moins autour du circuit intégré radiofréquence (11),
pour obtenir, sur le premier substrat porteur (31), une première partie du module frontal, puis
• un transfert de la première partie du module frontal depuis le premier substrat porteur (31) sur le second substrat porteur (32) par la face de la première partie du module frontal opposée à celle par laquelle la première partie du module frontal repose sur le premier substrat support (31),
de sorte que la première partie du module frontal puisse être traitée depuis sa surface exposée après son transfert, pour finir de former le module frontal (1), puis
• un dépôt d'un premier niveau métallique de connexion électrique (141) sur la surface exposée de la première partie du module frontal, de sorte à présenter deux parties électriquement disjointes entre elles, chacune constituant une partie de l'une parmi la piste métallique de connexion à la masse (13) et la piste métallique de connexion électrique de signal (14),
• un dépôt du deuxième matériau diélectrique (17) sur le premier niveau métallique de connexion électrique (141), puis une gravure du deuxième matériau diélectrique (17), de sorte à former une cavité (171) située en regard de la partie du premier niveau métallique (141) constituant une partie de la piste métallique de connexion électrique de signal (14) et destinée à loger le palet (12) et de sorte à former des vias (143) vers un deuxième niveau métallique de connexion électrique (142) pour chacune parmi la piste métallique de connexion à la masse (13) et la piste métallique de connexion électrique de signal (14),
• un report du palet (11) dans la cavité (171) formée,
• un dépôt du deuxième niveau métallique de connexion électrique (142) sur la surface du deuxième matériau diélectrique (17) et la surface principale exposée du palet (12), de sorte à former chacune parmi la piste métallique de connexion à la masse (13) et la piste métallique de connexion électrique de signal (14), en remplissant chaque via (143) formé, et
• une formation de pads d'entrée/sortie (144) du module frontal (1) sur le deuxième niveau métallique de connexion électrique (142).

15. Procédé de fabrication selon l'une quelconque des revendications 9 à 12, comprenant :
• un dépôt d'un des premier et deuxième niveaux métalliques de connexion électrique (141, 142) sur le premier substrat porteur (31), de sorte à présenter au moins deux parties électriquement disjointes entre elles, chacune constituant une partie de l'une parmi la piste métallique de connexion à la masse (13) et la piste métallique de connexion électrique de signal (14),
• un report du palet (12) sur une partie du niveau métallique (141, 142) précédemment déposé, cette partie constituant une partie de la piste métallique de connexion électrique de signal (14),
• une formation d'un pilier métallique de connexion électrique (19) sur chacune de deux parties électriquement disjointes entre elles du niveau métallique (141, 142) précédemment déposé,
• un dépôt de l'un parmi le premier matériau diélectrique (16) et le deuxième matériau diélectrique (17) sur le niveau métallique de connexion électrique (141, 142) précédemment déposé et au moins autour du palet (12),
• un dépôt d'un autre des deux niveaux métalliques de connexion électrique (141, 142) sur le matériau diélectrique précédemment déposé, une surface principale exposée du palet (12) et le sommet de chacun pilier métallique (19), de sorte à former chacune parmi la piste métallique de connexion à la masse (13) et la piste métallique de connexion électrique de signal (14),
• un report du circuit intégré radiofréquence (11) par sa face avant (113) sur l'autre des deux niveaux métalliques de connexion électrique (141, 142), de sorte à contacter électriquement chacune parmi la piste métallique de connexion à la masse (13) et la piste métallique de connexion électrique de signal (14),
• un dépôt du premier matériau diélectrique (16) sur l'autre des deux niveaux métalliques de connexion électrique (141, 142) au moins autour du circuit intégré radiofréquence (11),
pour obtenir, sur le premier substrat porteur (31), une première partie du module frontal,
• un transfert de la première partie du module frontal depuis le premier substrat porteur (31) sur le second substrat porteur (32) par la face de la première partie du module frontal opposée à celle par laquelle la première partie du module frontal repose sur le premier substrat support,
de sorte que la première partie du module frontal puisse être traitée depuis sa surface exposée après son transfert, pour finir de former le module frontal (1), puis
• une formation de pads d'entrée/sortie (144) du module frontal (1) sur le premier niveau métallique de connexion électrique (141).
